# EUROPEAN PATENT APPLICATION

(11) **EP 4 372 987 A1**
(43) Date of publication of application: **22.05.2024**
(21) Application number: 22841400.9
(22) Date of filing: 13.07.2022
(51) Int. Cl.: H03H 9/02, H03H 9/05, H03H 3/02

(54) **BULK ACOUSTIC WAVE RESONATOR DEVICE AND METHOD FOR FORMING SAME, FILTERING DEVICE, AND RADIO FREQUENCY FRONT END DEVICE**

(30) Priority: 16.07.2021 CN 202110808204
(71) Applicant: Changzhou Chemsemi Co., Ltd., Changzhou, Jiangsu 213166 (CN)
(72) Inventor: HAN, Xing, hangzhou, Jiangsu 213166 (CN); ZHOU, Jian, hangzhou, Jiangsu 213166 (CN)
(74) Representative: Piticco, Lorena
(86) International application number: PCT/CN2022/105362
(87) International publication number: WO 2023/284767

(57) **Abstract**

A bulk acoustic wave resonator device of the present invention comprises: a cavity; a first electrode layer, at least one end of the first electrode layer being located above or inside the cavity; a piezoelectric layer, the cavity and the first electrode layer being located on a first side of the piezoelectric layer; a second electrode layer located on a second side, a region where the first electrode layer, the second electrode layer and the piezoelectric layer overlap being a resonance region; a first passive structure located on the first side and having a first overlapping portion with at least one edge of the first electrode layer; and a second passive structure located on the second side and having a second overlapping portion with at least one edge of the second electrode layer. The first passive structure comprises: a first raised portion located inside the resonance region; and a first extension portion located outside the resonance region, wherein the first raised portion protrudes with respect to the first extension portion. The second passive structure comprises: a second raised portion located inside the resonance region; and a second extension portion located outside the resonance region, wherein the second raised portion protrudes with respect to the second extension portion. The present invention suppresses parasitic edge mode, and improves Zₚ and corresponding Q value.

## Description

### CROSS-REFERENCE TO RELATED APPLICATIONS

This application claims the benefit of priority to Chinese patent application No. 202110808204.8, filed on July 16, 2021, entitled "BULK ACOUSTIC WAVE RESONANCE DEVICE AND METHOD FOR FORMING SAME, FILTERING DEVICE, AND RADIO FREQUENCY FRONT-END DEVICE", the entire disclosures of which are incorporated herein by reference.

### TECHNICAL FIELD

The present disclosure relates to the technical field of semiconductors, and more particularly to a bulk acoustic wave resonance device and a method for forming the same, a filtering device and a radio frequency front-end device.

### BACKGROUND

A Radio Frequency (RF) front-end chip of a wireless communication device includes a Power Amplifier (PA), an antenna switch, a radio frequency filter, a multiplexer including a duplexer, and a Low Noise Amplifier (LNA), etc. The radio frequency filter includes a Surface Acoustic Wave (SAW) filter, a Bulk Acoustic Wave (BAW) filter, a Micro-Electro-Mechanical System (MEMS) filter, and an Integrated Passive Device (IPD) filter, etc.

As both a SAW resonator and a BAW resonator have a high quality value (Q value), a radio frequency filter including either a SAW resonator, namely a SAW filter, or a BAW resonator, namely a BAW filter, has low insertion loss and high out-band rejection, and thus become a mainstream radio frequency filter applied to wireless communication devices such as mobile phones and base stations. The Q value is a quality factor value of a resonator, and is defined by a center frequency divided by 3dB bandwidth of the resonator. An effective frequency of a SAW filter typically ranges from 0.4 GHz to 2.7 GHz and an effective frequency of a BAW filter typically ranges from 0.7 GHz to 7 GHz.

As wireless communication technology gradually evolves, more and more frequency bands are developed. Moreover, due to implementation of frequency band superposition technology such as carrier aggregation, mutual interference between wireless frequency bands becomes increasingly serious. High performance BAW technology can solve the problem of mutual interference between frequency bands. With the advent of the 5G era, wireless mobile networks have adopted higher communication frequency bands, and BAW technology can provide solutions to the filtering problem in the high-frequency band so far.

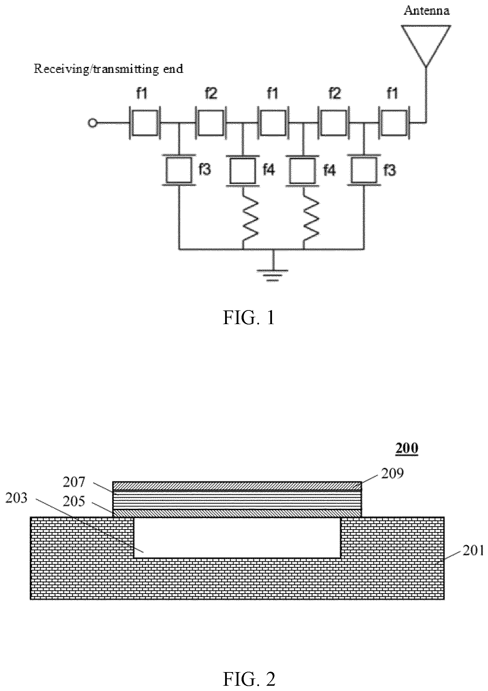

FIG. 1 illustrates a circuit of a BAW filter including a ladder circuit consisting of a plurality of BAW resonators, wherein f1, f2, f3 and f4 represent four different frequencies, respectively. A first end of the circuit is coupled with a receiving/transmitting end, and a second end of the circuit is coupled with an antenna. Within each BAW resonator, alternating voltages with different polarities are supplied to metal electrodes on both sides of a piezoelectric layer of the resonator, an acoustic wave is generated by the piezoelectric layer under the alternating voltages with different polarities, and the acoustic wave within the resonator propagates in a direction perpendicular to the piezoelectric layer. In order to form resonance, the acoustic wave requires total reflection on an upper surface of an upper metal electrode and on a lower surface of a lower metal electrode to form a standing acoustic wave. A condition for an acoustic wave reflection is that acoustic impedance of medium in contact with the upper surface of the upper metal electrode and the lower surface of the lower metal electrode differs greatly from that of the metal electrodes.

Performance of a filter depends on performance of a resonator, which is characterized by parameters such as a minimum series impedance Zₛ, a maximum parallel impedance Zₚ and an electromechanical coupling factor Kt² of the resonator. Zₛ and Zₚ represent electrical losses in the resonator, such as thermal losses, acoustic losses, etc. When the resonator operates at a series resonance frequency fs, a minimum input impedance value Zₛ is obtained; when the resonator operates at a parallel resonance frequency fp, a maximum input impedance Zₚ is obtained. The electromechanical coupling factor Kt² represents a frequency difference between Zₛ and Zₚ, which can affect a passband bandwidth of the filter. Resonators with higher Kt² or Zₚ and lower Zₛ have better performance. A person skilled in the art knows that resonator design requires a trade-off between Kt² and Zₚ, that is, raising Kt² will lead to a reduction to Zₚ, and raising Zₚ will lead to a reduction to Kt².

A Film Bulk Acoustic wave Resonator (FBAR) is a kind of BAW resonator which can restrain acoustic wave energy inside the resonator. Air or vacuum is configured above a resonance region of the BAW resonator, and a cavity is configured below the resonance region of the BAW resonator. Because acoustic impedance of air and vacuum differs greatly from that of metal electrodes, acoustic waves can be totally reflected on an upper surface of an upper metal electrode and a lower surface of a lower metal electrode to form standing waves.

FIG. 2 illustrates a structural schematic view of an FBAR 200. The FBAR 200 includes: a substrate 201, a cavity 203 disposed in the substrate 201, an electrode layer 205 (i.e., a lower electrode layer) disposed on the substrate 201 and covering the cavity 203, a piezoelectric layer 207 disposed on the electrode layer 205 and an electrode layer 209 (i.e., an upper electrode layer) disposed on the piezoelectric layer 207. An overlap region of the electrode layer 205, the piezoelectric layer 207 and the electrode layer 209 forms a resonance region of the FBAR 200. Two sets of acoustic waves are generated in the resonance region. A first set of acoustic waves includes longitudinal waves and shear waves propagating in a direction perpendicular to the piezoelectric layer 207, and a second set of acoustic waves includes acoustic waves propagating towards a lateral edge of the piezoelectric layer 207, where Rayleigh Lamb waves (RL waves) are included, which propagate along directions parallel to surfaces of two electrode layers to the lateral edge of the piezoelectric layer 207, and excites, at the lateral edge, a lateral spurious mode, resulting in spurious resonance and a reduction to Zₚ and corresponding Q value.

### SUMMARY

An objective of the present disclosure is to provide a bulk acoustic wave resonance device, which can decay transverse acoustic waves generated in a resonance region, so as to suppress a lateral spurious mode to improve Zₚ and corresponding Q value and moreover have a small impact on Kt², thereby improving a performance of a filtering device including the bulk acoustic wave resonance device, such as insertion losses and out-band rejection.

An embodiment of the present disclosure provides a bulk acoustic wave resonance device. The bulk acoustic wave resonance device includes: a cavity; a first electrode layer, wherein at least one end of the first electrode layer is disposed above or in the cavity; a piezoelectric layer, wherein the piezoelectric layer includes a first side and a second side opposite to the first side in a vertical direction, wherein the cavity is disposed at the first side, the first electrode layer is disposed at the first side, and the first electrode layer contacts the piezoelectric layer; a second electrode layer, disposed at the second side and contacting the piezoelectric layer, wherein an overlap region of the first electrode layer, the second electrode layer and the piezoelectric layer forms a resonance region; a first passive structure, disposed at the first side and having a first overlap portion overlapping with at least one edge of the first electrode layer; and a second passive structure, disposed at the second side and having a second overlap portion overlapping with at least one edge of the second electrode layer.

The first passive structure includes: a first raised portion, disposed in the resonance region and having the first overlap portion overlapping with the at least one edge of the first electrode layer, wherein the first raised portion is configured to make acoustic impedance matching of the resonance region and at least one evanescent region disposed outside the resonance region, so that more acoustic waves generated in the resonance region enter the at least one evanescent region; a first dielectric portion, disposed between the first raised portion and the first electrode layer for electrically isolating the first passive structure from the first electrode layer; and a first extension portion, disposed outside the resonance region and in the at least one evanescent region for decaying the acoustic waves entering the at least one evanescent region, wherein the first raised portion protrudes relative to the first extension portion.

The second passive structure includes: a second raised portion, disposed in the resonance region and having the second overlap portion overlapping with the at least one edge of the second electrode layer, wherein the second raised portion is configured to make acoustic impedance matching of the resonance region and the at least one evanescent region, so that more acoustic waves generated in the resonance region enter the at least one evanescent region; a second dielectric portion, disposed between the second raised portion and the second electrode layer for electrically isolating the second passive structure from the second electrode layer; and a second extension portion, disposed outside the resonance region and in the at least one evanescent region for decaying the acoustic waves entering the at least one evanescent region, wherein the second raised portion protrudes relative to the second extension portion.

According to some embodiments, the first passive structure and the second passive structure surround the resonance region.

According to some embodiments, a thickness of the first passive structure is equal to or less than a thickness of the first electrode layer, and a thickness of the second passive structure is equal to or less than a thickness of the second electrode layer.

According to some embodiments, the at least one evanescent region includes a first evanescent region having a first cutoff frequency equal to or less than a cutoff frequency of the resonance region, and the first evanescent region corresponds to an overlap region of the first extension portion, the piezoelectric layer and the second extension portion.

According to some embodiments, the bulk acoustic wave resonance device further includes: a first electrode extension layer, disposed at the first side and coupled with the first electrode layer; and a second electrode extension layer, disposed at the second side and coupled with the second electrode layer.

According to some embodiments, the at least one evanescent region includes a second evanescent region having a second cutoff frequency equal to or less than a cutoff frequency of the resonance region, and the second evanescent region corresponds to an overlap region of the second electrode extension layer, the piezoelectric layer and the first extension portion.

According to some embodiments, the at least one evanescent region includes a third evanescent region having a third cutoff frequency equal to or less than a cutoff frequency of the resonance region, and the third evanescent region corresponds to an overlap region of the second extension portion, the piezoelectric layer and the first electrode extension layer.

According to some embodiments, the at least one edge of the first electrode layer, corresponding to the first passive structure, has a ramp-down shape, and the at least one edge of the second electrode layer, corresponding to the second passive structure, has a ramp-down shape.

According to some embodiments, a width of the first raised portion is an integer multiple of a half wavelength of the acoustic waves generated in the resonance region, and a width of the second raised portion is an integer multiple of the half wavelength of the acoustic waves generated in the resonance region.

According to some embodiments, the first raised portion is made of a material including a metal, the first extension portion is made of a material including a metal, the second raised portion is made of a material including a metal, and the second extension portion is made of a material including a metal.

According to some embodiments, a thickness of the first extension portion is less than a thickness of the first electrode layer, and a thickness of the second extension portion is less than a thickness of the second electrode layer.

According to some embodiments, the first extension portion includes a first sub-portion and a second sub-portion, the second sub-portion and the piezoelectric layer are disposed at two opposite sides of the first sub-portion, and a material of the first sub-portion is different from a material of the second sub-portion.

According to some embodiments, the second extension portion includes a third sub-portion and a fourth sub-portion, the fourth sub-portion and the piezoelectric layer are disposed at two opposite sides of the third sub-portion, and a material of the third sub-portion is different from a material of the fourth sub-portion.

According to some embodiments, the first dielectric portion is made of a material selected from a group consisting of silicon dioxide, silicon oxynitride, silicon oxycarbide, silicon nitride, titanium oxide, aluminium oxide, hafnium silicate, zirconium silicate, hafnium dioxide and zirconium dioxide, and the second dielectric portion is made of a material selected from a group consisting of silicon dioxide, silicon oxynitride, silicon oxycarbide, silicon nitride, titanium oxide, aluminium oxide, hafnium silicate, zirconium silicate, hafnium dioxide and zirconium dioxide.

According to some embodiments, the first dielectric portion includes one selected from a group consisting of vacuum, air and helium, and the second dielectric portion includes one selected from a group consisting of vacuum, air and helium.

According to some embodiments, the first extension portion contacts the piezoelectric layer, and the second extension portion contacts the piezoelectric layer.

According to some embodiments, the first dielectric portion is further disposed between the piezoelectric layer and the first extension portion, and the second dielectric portion is further disposed between the piezoelectric layer and the second extension portion.

According to some embodiments, a first gap is disposed between the first extension portion and the piezoelectric layer, and a second gap is disposed between the piezoelectric layer and the second extension portion.

It should be noted that the raised portions of the passive structures are in the resonance region and have overlap portions overlapping with the electrode layers respectively, which can make acoustic impedance matching of the resonance region and the evanescent region disposed outside the resonance region, so that more acoustic waves generated in the resonance region can propagate into the evanescent region. In addition, the cutoff frequency of the evanescent region matches with (for example, equal to or less than) the cutoff frequency of the resonance region, which can result in decaying acoustic waves entering the evanescent region, so as to suppress lateral spurious mode to improve Zₚ and corresponding Q value. The cutoff frequency is a frequency corresponding to a wave number of 0 on a dispersion curve. In addition, the passive structures are not electrically coupled with the electrode layers, thus the impact of the passive structures on Kt² is relatively small.

Another embodiment of the present disclosure provides a filtering device. The filtering device includes at least one bulk acoustic wave resonance device according to any one of preceding embodiments.

Another embodiment of the present disclosure provides a radio frequency front-end device. The radio frequency front-end device includes a power amplification device and at least one filtering device according to any one of preceding embodiments, and the power amplification device is coupled with the filtering device.

Another embodiment of the present disclosure provides a radio frequency front-end device. The radio frequency front-end device includes a low noise amplification device and at least one filtering device according to any one of preceding embodiments, and the low noise amplification device is coupled with the filtering device.

Another embodiment of the present disclosure provides a radio frequency front-end device. The radio frequency front-end device includes a multiplexing device, and the multiplexing device includes at least one filtering device according to any one of preceding embodiments.

Another embodiment of the present disclosure provides a method for forming a bulk acoustic wave resonance device, including: forming a piezoelectric layer, wherein the piezoelectric layer includes a first side and a second side opposite to the first side in a vertical direction; forming a first electrode layer at the first side, wherein the first electrode layer contacts the piezoelectric layer; forming a second electrode layer at the second side, wherein the second electrode layer contacts the piezoelectric layer, and an overlap region of the first electrode layer, the second electrode layer and the piezoelectric layer forms a resonance region.

The method further includes: forming a first passive structure at the first side, wherein the first passive structure has a first overlap portion overlapping with at least one edge of the first electrode layer; wherein the first passive structure includes a first raised portion, a first dielectric portion and a first extension portion, and the first raised portion protrudes relative to the first extension portion; wherein the first raised portion is disposed in the resonance region and has the first overlap portion overlapping with the at least one edge of the first electrode layer, and the first raised portion is configured to make acoustic impedance matching of the resonance region and at least one evanescent region disposed outside the resonance region, so that more acoustic waves generated in the resonance region enter the at least one evanescent region; wherein the first dielectric portion is disposed between the first raised portion and the first electrode layer for electrically isolating the first passive structure from the first electrode layer; wherein the first extension portion is disposed outside the resonance region and in the at least one evanescent region for decaying the acoustic waves entering the at least one evanescent region.

The method further includes: forming a second passive structure at the second side, wherein the second passive structure has a second overlap portion overlapping with at least one edge of the second electrode layer; wherein the second passive structure includes a second raised portion, a second dielectric portion and a second extension portion, and the second raised portion protrudes relative to the second extension portion; wherein the second raised portion is disposed in the resonance region and has the second overlap portion overlapping with the at least one edge of the second electrode layer, and the second raised portion is configured to make acoustic impedance matching of the resonance region and the at least one evanescent region, so that more acoustic waves generated in the resonance region enter the at least one evanescent region; wherein the second dielectric portion is disposed between the second raised portion and the second electrode layer for electrically isolating the second passive structure from the second electrode layer; wherein the second extension portion is disposed outside the resonance region and in the at least one evanescent region for decaying the acoustic waves entering the at least one evanescent region.

According to some embodiments, the first passive structure and the second passive structure surround the resonance region.

According to some embodiments, a thickness of the first passive structure is equal to or less than a thickness of the first electrode layer, and a thickness of the second passive structure is equal to or less than a thickness of the second electrode layer.

According to some embodiments, forming the first electrode layer includes forming at least one edge, corresponding to the first passive structure, having a ramp-down shape, and forming the second electrode layer includes forming at least one edge, corresponding to the second passive structure, having a ramp-down shape.

According to some embodiments, forming the first passive structure includes: forming a first passivation layer at the first side covering the first electrode layer; and forming a first overlap layer contacting the first passivation layer and having the first overlap portion overlapping with the at least one edge of the first electrode layer; wherein the first passivation layer includes the first dielectric portion, and the first overlap layer includes the first raised portion and the first extension portion.

According to some embodiments, forming the second passive structure includes: forming a second passivation layer at the second side covering the second electrode layer; and forming a second overlap layer contacting the second passivation layer and having the second overlap portion overlapping with the at least one edge of the second electrode layer; wherein the second passivation layer includes the second dielectric portion, and the second overlap layer includes the second raised portion and the second extension portion.

According to some embodiments, a thickness of the first extension portion is less than a thickness of the first electrode layer, and a thickness of the second extension portion is less than a thickness of the second electrode layer.

According to some embodiments, the at least one evanescent region includes a first evanescent region having a first cutoff frequency equal to or less than a cutoff frequency of the resonance region, and the first evanescent region corresponds to an overlap region of the first extension portion, the piezoelectric layer and the second extension portion.

According to some embodiments, the method further includes: forming a first electrode extension layer coupling with the first electrode layer at the first side; and forming a second electrode extension layer coupling with the second electrode layer at the second side.

According to some embodiments, the at least one evanescent region includes a second evanescent region having a second cutoff frequency equal to or less than a cutoff frequency of the resonance region, and the second evanescent region corresponds to an overlap region of the second electrode extension layer, the piezoelectric layer and the first extension portion.

According to some embodiments, the at least one evanescent region includes a third evanescent region having a third cutoff frequency equal to or less than a cutoff frequency of the resonance region, and the third evanescent region corresponds to an overlap region of the second extension portion, the piezoelectric layer and the first electrode extension layer.

According to some embodiments, a width of the first raised portion is an integer multiple of a half wavelength of the acoustic waves generated in the resonance region, and a width of the second raised portion is an integer multiple of the half wavelength of the acoustic waves generated in the resonance region.

According to some embodiments, forming the first overlap layer includes forming a first overlap sub-layer and a second overlap sub-layer, the second overlap sub-layer and the piezoelectric layer are disposed at two opposite sides of the first overlap sub-layer, and a material of the first overlap sub-layer is different from a material of the second overlap sub-layer.

According to some embodiments, forming the second overlap layer includes forming a third overlap sub-layer and a fourth overlap sub-layer, the fourth overlap sub-layer and the piezoelectric layer are disposed at two opposite sides of the third overlap sub-layer, and a material of the third overlap sub-layer is different from a material of the fourth overlap sub-layer.

According to some embodiments, the method further includes: forming a first sacrificial layer between the first extension portion and the piezoelectric layer; and forming a second sacrificial layer between the second extension portion and the piezoelectric layer.

According to some embodiments, the method further includes: removing the first sacrificial layer to form a first gap between the first extension portion and the piezoelectric layer; and removing the second sacrificial layer to form a second gap between the second extension portion and the piezoelectric layer.

According to some embodiments, the first dielectric portion is further disposed between the piezoelectric layer and the first extension portion, and the second dielectric portion is further disposed between the piezoelectric layer and the second extension portion.

### BRIEF DESCRIPTION OF THE DRAWINGS

FIG. 1 illustrates a schematic structural view of a bulk acoustic wave filter circuit;
FIG. 2 illustrates a schematic structural view of an FBAR 200;
FIGS. 3 to 6 illustrate schematic structural views of a bulk acoustic wave resonance device 300 according to an embodiment of the present disclosure;
FIG. 7 illustrates a schematic structural view of a hexagonal crystal grain;
FIG. 8(i) illustrates a schematic structural view of an orthorhombic crystal grain;
FIG. 8(ii) illustrates a schematic structural view of a tetragonal crystal grain; and

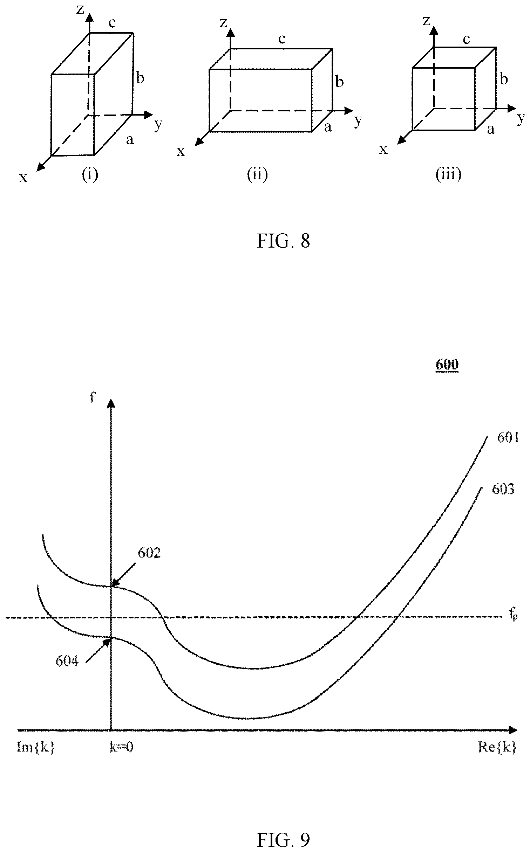

FIG. 8(iii) illustrates a schematic structural view of a cubic crystal grain;
FIG. 9 illustrates a schematic view of an acoustic wave dispersion curve 600 of a bulk acoustic wave resonance device according to an embodiment of the present disclosure;

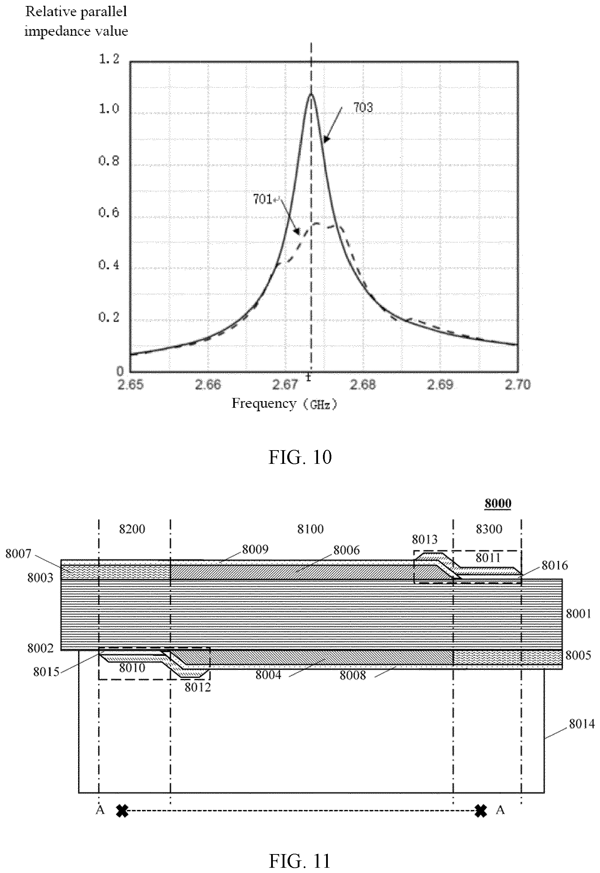

FIG. 10 illustrates a schematic view of a parallel impedance curve 700 of a bulk acoustic wave resonance device according to an embodiment of the present disclosure;
FIGS. 11 to 12 illustrate schematic structural views of a bulk acoustic wave resonance device 8000 according to an embodiment of the present disclosure;

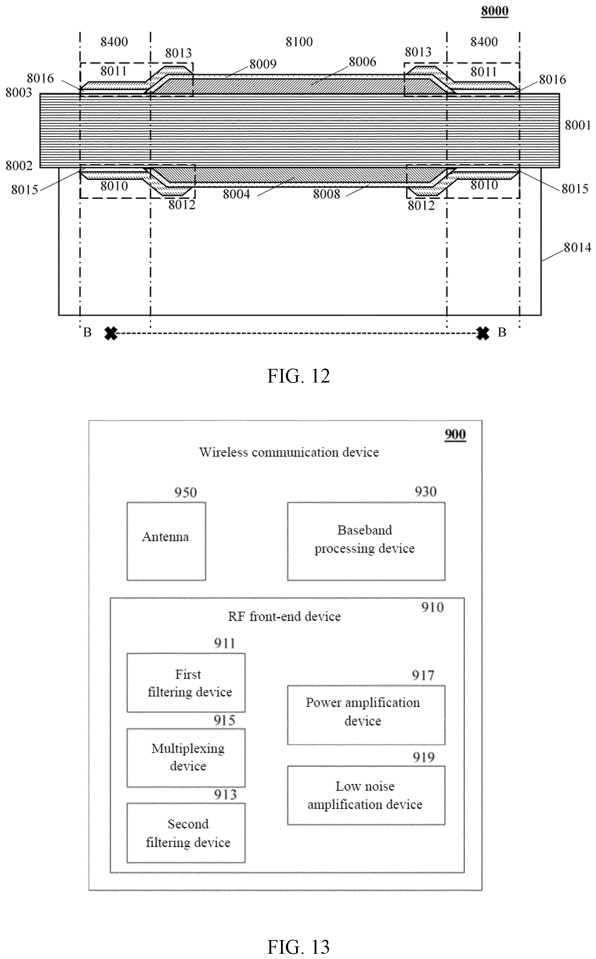

FIG. 13 illustrates a schematic structural view of a wireless communication device 900;

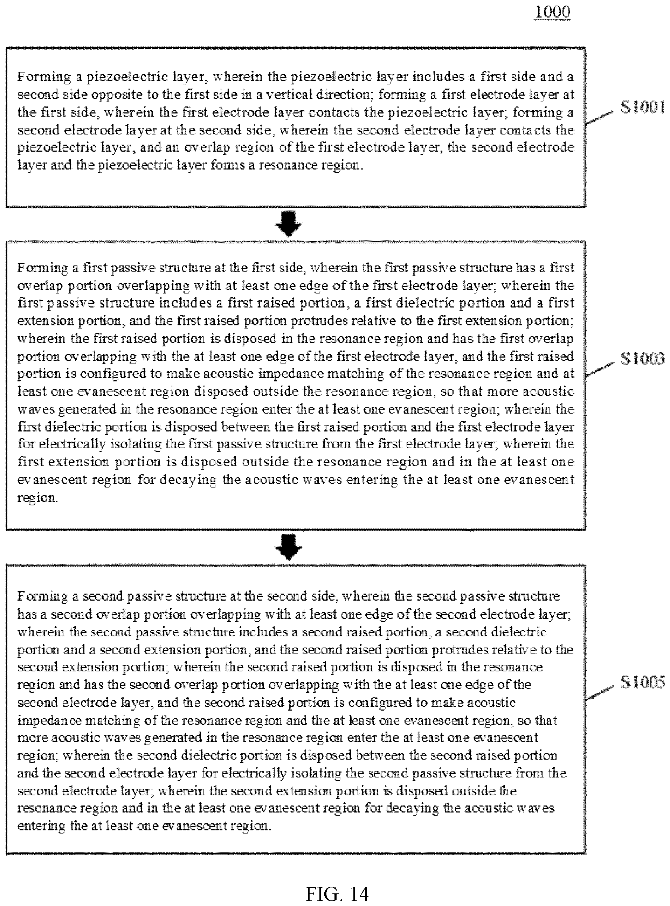

FIG. 14 illustrates a flowchart of a method 1000 for forming a bulk acoustic wave resonance device according to an embodiment of the present disclosure;

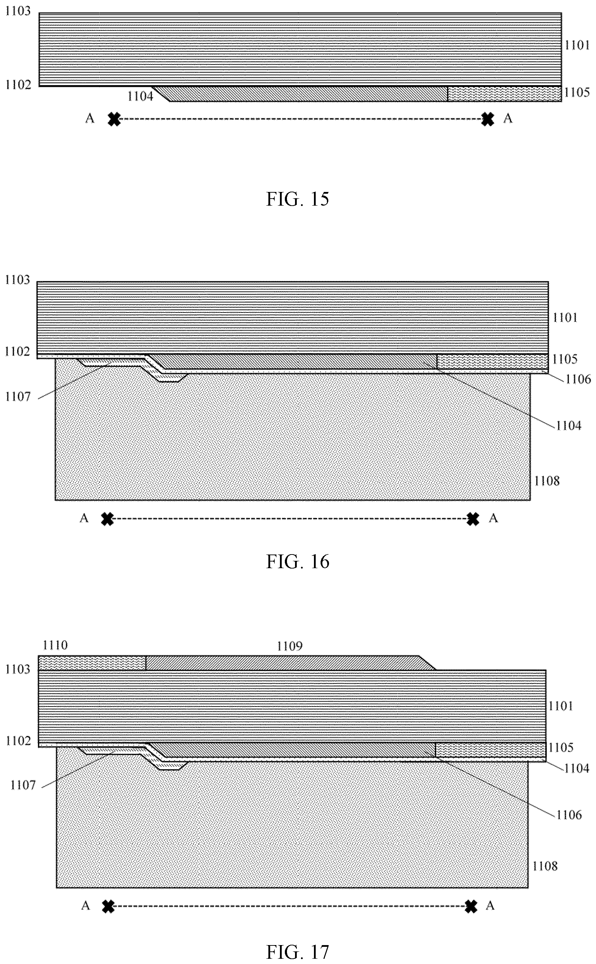

FIGS. 15 to 18 illustrate schematic structural views of section A during a method for forming a bulk acoustic wave resonance device 1100 according to an embodiment of the present disclosure; and

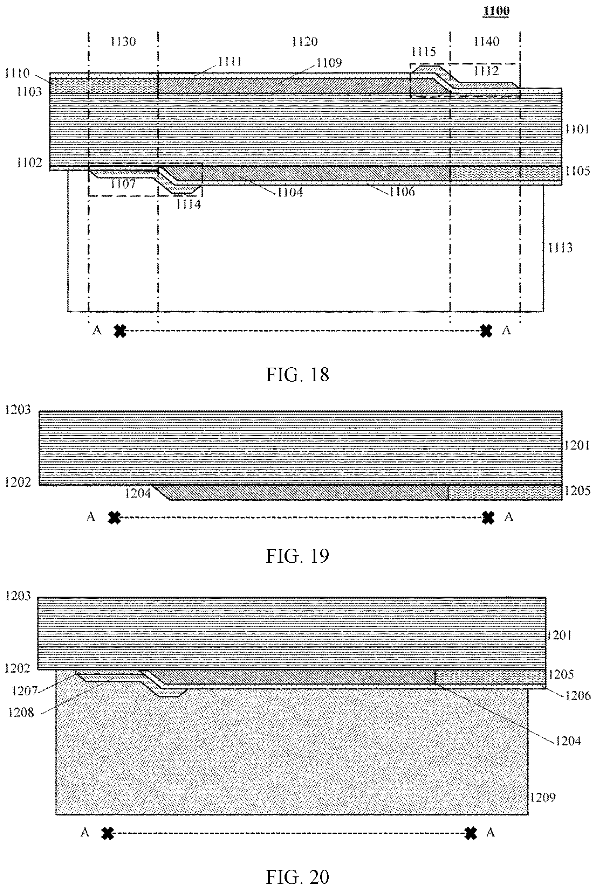

FIGS. 19 to 22 illustrate schematic structural views of section A during a method for forming a bulk acoustic wave resonance device 1200 according to an embodiment of the present disclosure.

### DETAILED DESCRIPTION

In order to make above-mentioned purpose, feature and advantage of the present disclosure more obvious and understandable, specific embodiments of the present disclosure will be described in detail below in conjunction with the accompanying drawings.

In following description, specific details are set forth in order to provide a thorough understanding of the present disclosure, but the present disclosure may be practiced otherwise than as specifically described herein, and therefore the present disclosure is not limited by the specific embodiments disclosed below.

As mentioned above, acoustic waves generated in a resonance region propagate along directions parallel to surfaces of two electrode layers to a lateral edge of a piezoelectric layer, so as to excite, at the lateral edges, a lateral spurious mode, which results in spurious resonance and leads to a reduction to Zₚ and corresponding Q value.

It has been found that the raised portions of the passive structures are disposed in the resonance region and have overlap portions overlapping with the electrode layers respectively, which can make acoustic impedance matching of the resonance region and the evanescent region outside the resonance region, so that more acoustic waves generated in the resonance region can propagate into the evanescent region. In addition, the cutoff frequency of the evanescent region matches with (for example, equal to or less than) the cutoff frequency of the resonance region, which can decay the acoustic waves entering the evanescent region, so as to suppress lateral spurious mode to improve Zₚ and corresponding Q value. The cutoff frequency is a frequency corresponding to a wave number of 0 on a dispersion curve. In addition, the passive structures are not electrically coupled with the electrode layers, thus the impact of the passive structures on Kt² is relatively small.

Therefore, an embodiment of the present disclosure provides a bulk acoustic wave resonance device, including: a cavity; a first electrode layer, wherein at least one end of the first electrode layer is disposed above or in the cavity; a piezoelectric layer, wherein the piezoelectric layer includes a first side and a second side opposite to the first side in a vertical direction, wherein the cavity is disposed at the first side, the first electrode layer is disposed at the first side, and the first electrode layer contacts the piezoelectric layer; a second electrode layer, disposed at the second side and contacting the piezoelectric layer, wherein an overlap region of the first electrode layer, the second electrode layer and the piezoelectric layer forms a resonance region; a first passive structure, disposed at the first side and having a first overlap portion overlapping with at least one edge of the first electrode layer; and a second passive structure, disposed at the second side and having a second overlap portion overlapping with at least one edge of the second electrode layer.

The first passive structure includes: a first raised portion, disposed in the resonance region and having the first overlap portion overlapping with the at least one edge of the first electrode layer, wherein the first raised portion is configured to make acoustic impedance matching of the resonance region and at least one evanescent region disposed outside the resonance region, so that more acoustic waves generated in the resonance region enter the at least one evanescent region; a first dielectric portion, disposed between the first raised portion and the first electrode layer for electrically isolating the first passive structure from the first electrode layer; and a first extension portion, disposed outside the resonance region and in the at least one evanescent region for decaying the acoustic waves entering the at least one evanescent region, wherein the first raised portion protrudes relative to the first extension portion.

The second passive structure includes: a second raised portion, disposed in the resonance region and having the second overlap portion overlapping with the at least one edge of the second electrode layer, wherein the second raised portion is configured to make acoustic impedance matching of the resonance region and the at least one evanescent region, so that more acoustic waves generated in the resonance region enter the at least one evanescent region; a second dielectric portion, disposed between the second raised portion and the second electrode layer for electrically isolating the second passive structure from the second electrode layer; and a second extension portion, disposed outside the resonance region and in the at least one evanescent region for decaying the acoustic waves entering the at least one evanescent region, wherein the second raised portion protrudes relative to the second extension portion.

According to some embodiments, the first passive structure and the second passive structure surround the resonance region.

According to some embodiments, a thickness of the first passive structure is equal to or less than a thickness of the first electrode layer, and a thickness of the second passive structure is equal to or less than a thickness of the second electrode layer.

According to some embodiments, the at least one evanescent region includes a first evanescent region having a first cutoff frequency equal to or less than a cutoff frequency of the resonance region, and the first evanescent region corresponds to an overlap region of the first extension portion, the piezoelectric layer and the second extension portion.

According to some embodiments, the bulk acoustic wave resonance device further includes: a first electrode extension layer, disposed at the first side and coupled with the first electrode layer; and a second electrode extension layer, disposed at the second side and coupled with the second electrode layer.

According to some embodiments, the at least one evanescent region includes a second evanescent region having a second cutoff frequency equal to or less than a cutoff frequency of the resonance region, and the second evanescent region corresponds to an overlap region of the second electrode extension layer, the piezoelectric layer and the first extension portion.

According to some embodiments, the at least one evanescent region includes a third evanescent region having a third cutoff frequency equal to or less than a cutoff frequency of the resonance region, and the third evanescent region corresponds to an overlap region of the second extension portion, the piezoelectric layer and the first electrode extension layer.

According to some embodiments, the at least one edge of the first electrode layer, corresponding to the first passive structure, has a ramp-down shape, and the at least one edge of the second electrode layer, corresponding to the second passive structure, has a ramp-down shape.

According to some embodiments, a width of the first raised portion is an integer multiple of a half wavelength of the acoustic waves generated in the resonance region, and a width of the second raised portion is an integer multiple of the half wavelength of the acoustic waves generated in the resonance region.

According to some embodiments, the first raised portion is made of a material including a metal, the first extension portion is made of a material including a metal, the second raised portion is made of a material including a metal, and the second extension portion is made of a material including a metal.

According to some embodiments, a thickness of the first extension portion is less than a thickness of the first electrode layer, and a thickness of the second extension portion is less than a thickness of the second electrode layer.

According to some embodiments, the first extension portion includes a first sub-portion and a second sub-portion, the second sub-portion and the piezoelectric layer are disposed at two opposite sides of the first sub-portion, and a material of the first sub-portion is different from a material of the second sub-portion.

According to some embodiments, the second extension portion includes a third sub-portion and a fourth sub-portion, the fourth sub-portion and the piezoelectric layer are disposed at two opposite sides of the third sub-portion, and a material of the third sub-portion is different from a material of the fourth sub-portion.

According to some embodiments, the first dielectric portion is made of a material selected from a group consisting of silicon dioxide, silicon oxynitride, silicon oxycarbide, silicon nitride, titanium oxide, aluminium oxide, hafnium silicate, zirconium silicate, hafnium dioxide and zirconium dioxide, and the second dielectric portion is made of a material selected from a group consisting of silicon dioxide, silicon oxynitride, silicon oxycarbide, silicon nitride, titanium oxide, aluminium oxide, hafnium silicate, zirconium silicate, hafnium dioxide and zirconium dioxide.

According to some embodiments, the first dielectric portion includes one selected from a group consisting of vacuum, air and helium, and the second dielectric portion includes one selected from a group consisting of vacuum, air and helium.

According to some embodiments, the first extension portion contacts the piezoelectric layer, and the second extension portion contacts the piezoelectric layer.

According to some embodiments, the first dielectric portion is further disposed between the piezoelectric layer and the first extension portion, and the second dielectric portion is further disposed between the piezoelectric layer and the second extension portion.

According to some embodiments, a first gap is disposed between the first extension portion and the piezoelectric layer, and a second gap is disposed between the piezoelectric layer and the second extension portion.

It should be noted that the raised portions of the passive structures are disposed in the resonance region and have overlap portions overlapping with the electrode layers respectively, which can make acoustic impedance matching of the resonance region and the evanescent region outside the resonance region, so that more acoustic waves generated in the resonance region can propagate into the evanescent region. In addition, the cutoff frequency of the evanescent region matches with (for example, equal to or less than) the cutoff frequency of the resonance region, which can decay acoustic waves entering the evanescent region, so as to suppress lateral spurious mode to improve Zₚ and corresponding Q value. The cutoff frequency is a frequency corresponding to a wave number of 0 on a dispersion curve. In addition, the passive structures are not electrically coupled with the electrode layers, thus the impact of the passive structures on Kt² is relatively small.

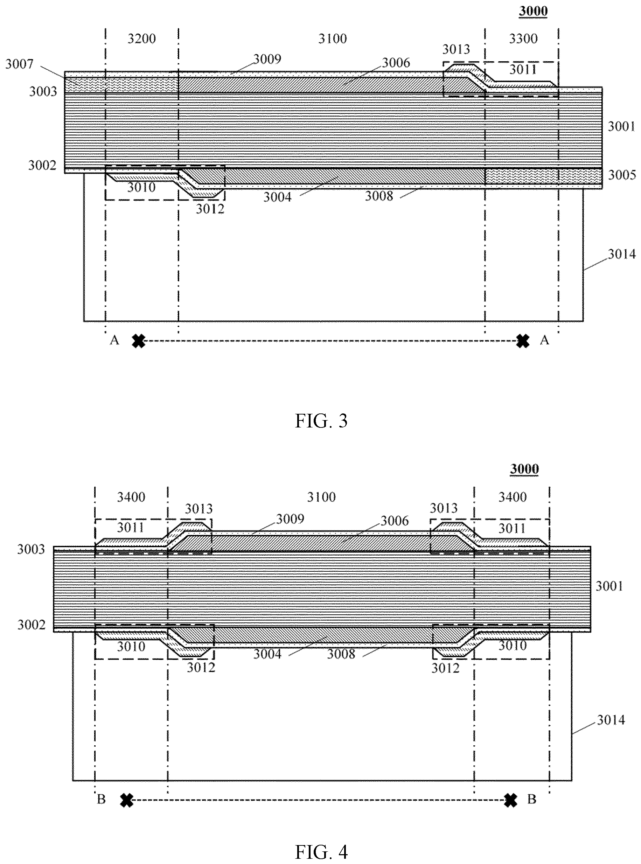

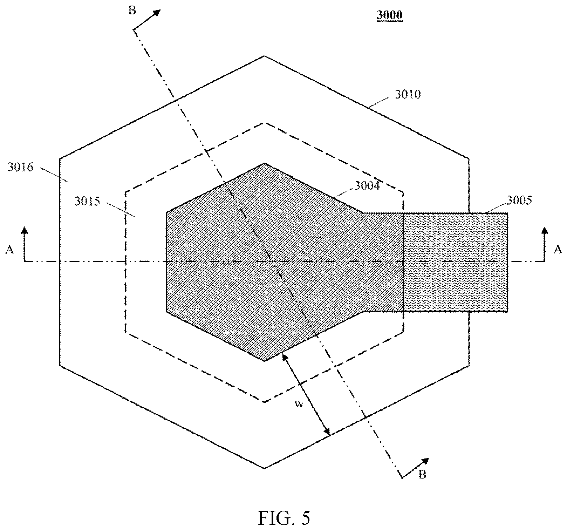

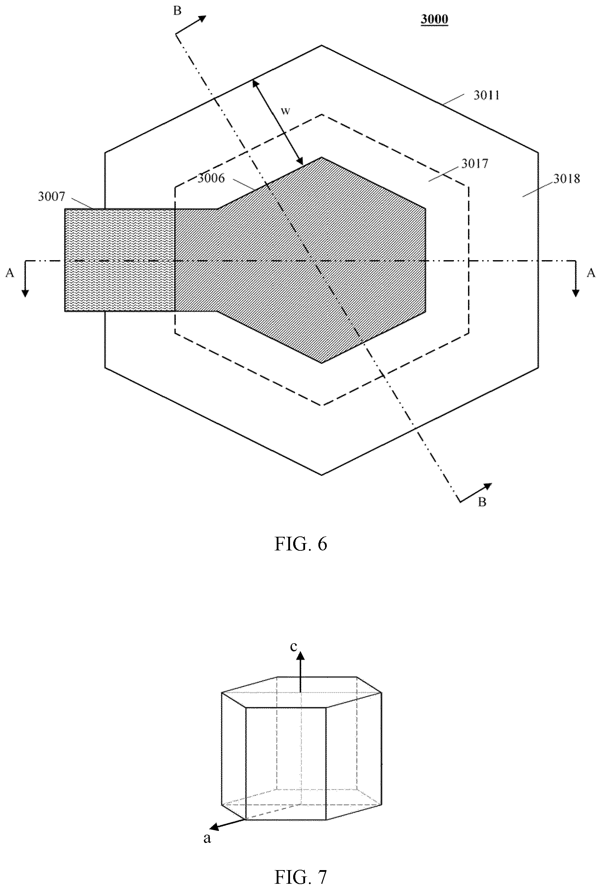

FIGS. 3 to 6 illustrate specific embodiments of a bulk acoustic wave resonance device of the present disclosure, but the present disclosure can also be implemented in other ways different from the specific embodiments described here, so the present disclosure is not limited by the specific embodiments disclosed below. FIG. 3 illustrates a schematic structure view of a first cross-section of the bulk acoustic wave resonance device, FIG. 4 illustrates a schematic structure view of a second cross-section of the bulk acoustic wave resonance device, FIG. 5 illustrates a schematic structure view of a first top side of a first electrode layer of the body acoustic wave resonance device relative to the first cross-section, and FIG. 6 illustrates a schematic structure view of a second top side of a second electrode layer of the body acoustic wave resonance device relative to the first cross-section.

FIG. 3 illustrates a schematic structure view of a cross-section A of a bulk acoustic wave resonance device 3000.

As shown in FIG. 3, the bulk acoustic wave resonance device 3000 includes a piezoelectric layer 3001, a first electrode layer 3004, a first electrode extension layer 3005, a second electrode layer 3006, a second electrode extension layer 3007, a first passivation layer 3008, a second passivation layer 3009, a first overlap layer 3010 and a second overlap layer 3011. The piezoelectric layer 3001 includes a first side 3002 and a second side 3003 opposite to the first side 3002 in a vertical direction. The first electrode layer 3004 is disposed at the first side 3002 and contacts the piezoelectric layer 3001. The first electrode layer 3004 includes a first edge and a second edge opposite to the first edge in a horizontal direction, and the first edge has a ramp-down shape. The first electrode extension layer 3005 is disposed at the first side 3002. The first electrode extension layer 3005 contacts the piezoelectric layer 3001 and is coupled with the second edge. The second electrode layer 3006 is disposed at the second side 3003 and contacts the piezoelectric layer 3001. The second electrode layer 3006 includes a third edge and a fourth edge opposite to the third edge in the horizontal direction, and the fourth edge has a ramp-down shape. The second electrode extension layer 3007 is disposed at the second side 3003. The second electrode extension layer 3007 contacts the piezoelectric layer 3001 and is coupled with the third edge. An overlap region of the first electrode layer 3004, the second electrode layer 3006 and the piezoelectric layer 3001 forms a resonance region 3100. The first edge corresponds to the third edge in the vertical direction, and the second edge corresponds to the fourth edge in the vertical direction. The first electrode extension layer 3005 and the second electrode extension layer 3007 are disposed outside the resonance region 3100, and there is no overlap portion between the first electrode extension layer 3005 and the second electrode extension layer 3007. The first passivation layer 3008 is disposed at the first side 3002. One part of the first passivation layer 3008 in the resonance region 3100 covers the first electrode layer 3004, and the other part of the first passivation layer 3008 outside the resonance region 3100 covers the piezoelectric layer 3001 outside the first edge and the first electrode extension layer 3005 outside the second edge. The second passivation layer 3009 is disposed at the second side 3003. One part of the second passivation layer 3009 in the resonance region 3100 covers the second electrode layer 3006, and the other part of the second passivation layer 3009 outside the resonance region 3100 covers the second electrode extension layer 3007 outside the third edge and the piezoelectric layer 3001 outside the fourth edge. The first overlap layer 3010 is disposed at the first side 3002 and contacts the first passivation layer 3008. The first overlap layer 3010 includes a first raised portion (not marked) and a first extension portion (not marked). The first raised portion protrudes relative to the first extension portion. The first raised portion is in the resonance region 3100, and overlaps with the first electrode layer 3004 at the first edge. The first raised portion and the first electrode layer 3004 are disposed at two opposite sides of the first passivation layer 3008. The first extension portion is outside the resonance region 3100 and outside the first edge as well, and the first extension portion does not overlap with the first electrode layer 3004. The first extension portion and the piezoelectric layer 3001 are disposed at two opposite sides of the first passivation layer 3008 along the vertical direction. The second overlap layer 3011 is disposed at the second side 3003 and contacts the second passivation layer 3009. The second overlap layer 3011 includes a second raised portion (not marked) and a second extension portion (not marked). The second raised portion protrudes relative to the second extension portion. The second raised portion is in the resonance region 3100, and overlaps with the second electrode layer 3006 at the fourth edge. The second raised portion and the second electrode layer 3006 are disposed at two opposite sides of the second passivation layer 3009. The second extension portion is outside the resonance region 3100 and outside the fourth edge as well, and the second extension portion does not overlap with the second electrode layer 3006. The second extension portion and the piezoelectric layer 3001 are disposed at two opposite sides of the second passivation layer 3009 along the vertical direction.

In some embodiments, the material of the piezoelectric layer 3001 includes, but is not limited to, one of the following: aluminum nitride, aluminum nitride alloy, gallium nitride, zinc oxide, lithium tantalate, lithium niobate, lead zirconate titanate (PZT), and lead magnesium niobate-lead titanate.

In some embodiments, the piezoelectric layer 3001 is a flat layer. The piezoelectric layer 3001 includes a plurality of crystal grains. The plurality of crystal grains include a first crystal grain and a second crystal grain, and the first crystal grain and the second crystal grain are any two crystal grains of the plurality of crystal grains. It should be understood by those skilled in the art that crystal orientation and crystal plane of a crystal grain can be represented based on a coordinate system. As shown in FIG. 7, a hexagonal crystal grain, such as an aluminum nitride crystal grain, may be represented by an ac stereoscopic coordinate system (including a-axis and c-axis). As shown in FIG. 8, the crystal grains of (i) orthorhombic system (a ≠ b ≠ c), (ii) tetragonal system (a = b ≠c), (iii) cubic system (a = b = c), etc., may be represented by an xyz stereoscopic coordinate system (including x-axis, y-axis and z-axis). In addition to the two embodiments described above, crystal grains may also be represented based on other coordinate systems known to those skilled in the art, and therefore the present disclosure is not limited by the two embodiments described above.

In some embodiments, the first crystal grain may be represented based on a first stereoscopic coordinate system, and the second crystal grain may be represented based on a second stereoscopic coordinate system. The first stereoscopic coordinate system includes at least a first coordinate axis along a first direction and a third coordinate axis along a third direction, and the second stereoscopic coordinate system includes at least a second coordinate axis along a second direction and a fourth coordinate axis along a fourth direction. The first coordinate axis corresponds to a height of the first crystal grain, and the second coordinate axis corresponds to a height of the second crystal grain.

In some embodiments, the first direction is the same as or opposite to the second direction. It should be noted that the first direction being the same as the second direction means that an included angle between a vector along the first direction and a vector along the second direction ranges from 0 degree to 5 degrees, and the first direction being opposite to the second direction means that the included angle between the vector along the first direction and the vector along the second direction ranges from 175 degrees to 180 degrees.

In some embodiments, the first stereoscopic coordinate system is an ac stereoscopic coordinate system, wherein the first coordinate axis is a first c-axis and the third coordinate axis is a first a-axis. The second stereoscopic coordinate system is an ac stereoscopic coordinate system, wherein the second coordinate axis is a second c-axis, and the fourth coordinate axis is a second a-axis. The first c-axis and the second c-axis have the same or opposite orientation.

In some embodiments, the first stereoscopic coordinate system further includes a fifth coordinate axis along a fifth direction and the second stereoscopic coordinate system further includes a sixth coordinate axis along a sixth direction. In some embodiments, the first direction is the same as or opposite to the second direction, and the third direction is the same as or opposite to the fourth direction. It should be noted that the third direction being the same as the fourth direction means that an included angle between a vector along the third direction and a vector along the fourth direction ranges from 0 degree to 5 degrees, and the third direction being opposite to the fourth direction means that the included angle between the vector along the third direction and the vector along the fourth direction ranges from 175 degrees to 180 degrees.

In some embodiments, the first stereoscopic coordinate system is an xyz stereoscopic coordinate system, wherein the first coordinate axis is a first z-axis, the third coordinate axis is a first y-axis, and the fifth coordinate axis is a first x-axis. The second stereoscopic coordinate system is an xyz stereoscopic coordinate system, wherein the second coordinate axis is a second z-axis, the fourth coordinate axis is a second y-axis, and the sixth coordinate axis is a second x-axis. In some embodiments, the first z-axis and the second z-axis have the same orientation, and the first y-axis and the second y-axis have the same orientation. In some embodiments, the first z-axis and the second z-axis have opposite orientation, and the first y-axis and the second y-axis have opposite orientation. In some embodiments, the first z-axis and the second z-axis have the same orientation, and the first y-axis and the second y-axis have opposite orientation. In some embodiments, the first z-axis and the second z-axis have opposite orientation, and the first y-axis and the second y-axis have the same orientation.

In some embodiments, the piezoelectric layer 3001 includes a plurality of crystal grains and a crystal composed of the plurality of crystal grains has a full width at half maximum of rocking curve less than 2.5 degrees. It should be noted that the rocking curve describes a magnitude of angular divergence of a particular crystal plane (a crystal plane determined by a diffraction angle) in a sample, which is represented by a plane coordinate system, wherein an abscissa represents an angle between the crystal plane and a sample plane, and an ordinate represents a diffraction intensity of the crystal plane at a certain angle. The rocking curve is used to represent quality of the crystal, and the smaller the full width at half maximum is, the better the quality of the crystal is. In addition, the Full Width at Half Maximum (FWHM) refers to an interval between two points whose function values are equal to a half of a peak value of the function.

In some embodiments, the material of the first electrode layer 3004 includes, but is not limited to, at least one of the following: molybdenum, ruthenium, tungsten, platinum, iridium, aluminum and beryllium, and the material of the first electrode extension layer 3005 includes, but is not limited to, at least one of the following: molybdenum, ruthenium, tungsten, platinum, iridium, aluminum, beryllium, copper and gold. In some embodiments, the material of the first electrode layer 3004 may be the same as that of the first electrode extension layer 3005.

In some embodiments, the material of the second electrode layer 3006 includes, but is not limited to, at least one of the following: molybdenum, ruthenium, tungsten, platinum, iridium, aluminum and beryllium, and the material of the second electrode extension layer 3007 includes, but is not limited to, at least one of the following: molybdenum, ruthenium, tungsten, platinum, iridium, aluminum, beryllium, copper and gold. In some embodiments, the material of the first electrode layer 3006 may be the same as that of the first electrode extension layer 3007.

In some embodiments, the material of the electrode layer may be different from that of the electrode extension layer.

In some embodiments, the material of the first passivation layer 3008 includes, but is not limited to, one of the following: silicon dioxide, silicon oxynitride, silicon oxycarbide, silicon nitride, titanium oxide, aluminium oxide, hafnium silicate, zirconium silicate, hafnium dioxide, and zirconium dioxide. In some embodiments, the material of the second passivation layer 3009 includes, but is not limited to one of the following: silicon dioxide, silicon oxynitride, silicon oxycarbide, silicon nitride, titanium oxide, aluminium oxide, hafnium silicate, zirconium silicate, hafnium dioxide, and zirconium dioxide. In some embodiments, the material of the first passivation layer 3008 may be the same as that of the second passivation layer 3009. In other embodiments, the material of the first passivation layer (e.g., the first passivation layer 3008) may be different from that of the second passivation layer (e.g., the second passivation layer 3009).

In some embodiments, the material of the first overlap layer 3010 includes, but is not limited to, at least one of the following: molybdenum, ruthenium, tungsten, platinum, iridium, aluminum and beryllium. In some embodiments, the material of the first overlap layer 3010 may be the same as that of the first electrode layer 3004.

In some embodiments, the material of the second overlap layer 3011 includes, but is not limited to, at least one of the following: molybdenum, ruthenium, tungsten, platinum, iridium, aluminum and beryllium. In some embodiments, the material of the second overlap layer 3011 may be the same as that of the second electrode layer 3006.

In other embodiments, the material of the overlap layer may be different from that of the electrode layer, for example, the material of the overlap layer is tungsten or platinum, and the material of the electrode layer is molybdenum.

In some embodiments, the overlap layer includes a first overlap sub-layer and a second overlap sub-layer. The first overlap sub-layer contacts the passivation layer, the second overlap sub-layer contacts the first overlap sub-layer, and the second overlap sub-layer and the passivation layer are disposed at two opposite sides of the first overlap sub-layer. The material of the first overlap sub-layer may be different from that of the second overlap sub-layer, for example, the material of the first overlap sub-layer is molybdenum, and the material of the second overlap sub-layer is platinum or tungsten.

In some embodiments, the bulk acoustic wave resonance device 3000 further includes a first passive structure 3012 and a second passive structure 3013. The first passive structure 3012 is disposed at the first side 3002 and contacts the first edge of the first electrode layer 3004 and the piezoelectric layer 3001 outside the first edge. The first passive structure 3012 includes the first overlap layer 3010 and a first dielectric portion (not marked) that is a part of the first passivation layer 3008 overlapping with the first overlap layer 3010. The second passive structure 3013 is disposed at the second side 3003 and contacts the fourth edge of the second electrode layer 3006 and the piezoelectric layer 3001 outside the fourth edge. The second passive structure 3013 includes the second overlap layer 3011 and a second dielectric portion (not marked) that is a part of the second passivation layer 3009 overlapping with the second overlap layer 3011. It should be noted that the dielectric portion can electrically isolate the overlap layers from the electrode layers, so that the electrode layers and the overlap layers are not electrically coupled, thus the overlap layers are passive, and thus a combination structure of the dielectric portions and the overlap layers is also passive.

In some embodiments, a first thickness of the first passive structure 3012 is less than a thickness of the first electrode layer 3004, a second thickness of the second passive structure 3013 is less than a thickness of the second electrode layer 3006, and the first thickness is equal to or approximately equal to the second thickness.

In some embodiments, a first width of the first raised portion matches with a wavelength of major-mode transverse acoustic waves generated in the resonance region 3100, such as Rayleigh-Lamb 1st order mode or 1st order Thickness Extension mode (for example, the first width is an integer multiple of half the wavelength). A second width of the second raised portion matches with the wavelength of the major-mode transverse acoustic waves generated in the resonance region 3100 (for example, the second width is equal to an integer multiple of half the wavelength), and the first width is equal to or approximately equal to the second width. It should be noted that the first raised portion and the second raised portion are used to make acoustic impedance matching of the resonance region and the evanescent region, so that more acoustic waves generated in the resonance region can propagate into the evanescent region.

In some embodiments, a third thickness of the first extension portion is less than the thickness of the first electrode layer 3004, a fourth thickness of the second extension portion is less than the thickness of the second electrode layer 3006, and the third thickness is equal to or approximately equal to the fourth thickness.

In some embodiments, an overlap region of the first extension portion, the second electrode extension layer 3007 and the piezoelectric layer 3001 forms an evanescent region 3200, and an overlap region of the second extension portion, the first electrode extension layer 3005 and the piezoelectric layer 3001 forms an evanescent region 3300. A first cutoff frequency of the evanescent region 3200 matches with (for example, equal to or less than) a cutoff frequency of the resonance region 3100, a second cutoff frequency of the evanescent region 3300 matches with (for example, equal to or less than) the cutoff frequency of the resonance region 3100, and the first cutoff frequency is equal to or approximately equal to the second cutoff frequency.

It should be noted that the cutoff frequency of the evanescent region matches with (for example, equal to or less than) the cutoff frequency of the resonance region, which results in the acoustic waves entering the evanescent region are in the evanescent mode, that is, the wave number in the evanescent region only includes an imaginary part, resulting in an exponential decay of the acoustic waves. In order to more clearly illustrate the advantages of the embodiments of the present disclosure, as shown in FIG. 9, which illustrates two exemplary Type II acoustic wave dispersion curves 600. A horizontal axis of the dispersion curve coordinate system represents a wave number, a vertical axis represents a frequency, and an origin of the coordinate system represents a zero wave number. A left side axis to the origin indicates that the wave number only contains an imaginary part, and a right side axis to the origin indicates that the wave number only contains a real part. As shown in FIG. 9, a first dispersion curve 601 represents a dispersion relationship of the resonance region, and an intersection of the first dispersion curve 601 and the vertical axis represents a first cutoff frequency 602 of the resonance region. A second dispersion curve 603 represents a dispersion relationship of the evanescent region, an intersection of the second dispersion curve 603 and the vertical axis represents a second cutoff frequency 604 of the evanescent region, and the second cutoff frequency 604 is smaller than the first cutoff frequency 602. Referring to FIG. 9, at a parallel resonance frequency fp, the wave number of the first dispersion curve 601 only includes a real part, and the wave number of the second dispersion curve 603 only includes an imaginary part. Therefore, the acoustic waves propagate from the resonance region into the evanescent region and the evanescent mode is excited, so that the acoustic waves have an exponential decay. Specifically, an expression for an acoustic wave displacement includes exp (-jkx), where a wave number k only includes an imaginary part. It should be noted that Type I acoustic wave dispersion curve has similar dispersion characteristics.

FIG. 10 illustrates two parallel impedance curves, where a horizontal axis represents a frequency and a vertical axis represents a relative parallel impedance value. The relative parallel impedance value represents a ratio of an absolute parallel impedance value to a specific parallel impedance value. For example, if the absolute parallel impedance value is 300 ohms and the specific parallel impedance value is 500 ohms, the relative parallel impedance value is 0.6 (300/500). Referring to FIG. 10, a first parallel impedance curve 701 represents a relative parallel impedance curve of a bulk acoustic wave resonance device without a passive structure, and a second parallel impedance curve 703 represents a relative parallel impedance curve of a bulk acoustic wave resonance device with a passive structure. As shown in FIG. 10, for the parallel resonance frequency fp, a corresponding value on the second parallel impedance curve 703 is greater than a corresponding value on the first parallel impedance curve 701. It should be noted that the passive structures can decay the transverse acoustic waves generated in the resonance region, so as to suppress lateral spurious mode to improve Zₚ and corresponding Q value. In addition, the passive structures are not electrically coupled with an electrode layers, thus the impact of the passive structure on Kt² is relatively small.

In some embodiments, the bulk acoustic wave resonance device 3000 further includes a cavity 3014. The first electrode layer 3004 is disposed in the cavity 3014, one end of the first electrode extension layer 3005 is disposed in the cavity 3014, and the first passive structure 3012 is disposed in the cavity 3014. In other embodiments, a lower electrode layer (i.e., the first electrode layer 3004) may be disposed above the cavity and cover the cavity. The passive structure corresponding to the lower electrode layer may be disposed outside the cavity.

FIG. 4 illustrates a schematic structure view of a cross-section B of the bulk acoustic wave resonance device 3000 according to an embodiment of the present disclosure.

As shown in FIG. 4, the bulk acoustic wave resonance device 3000 includes the piezoelectric layer 3001, the first electrode layer 3004, the second electrode layer 3006, the first passivation layer 3008, the second passivation layer 3009, the first overlap layer 3010 and the second overlap layer 3011. The piezoelectric layer 3001 includes the first side 3002 and the second side 3003. The first electrode layer 3004 is disposed at the first side 3002 and contacts the piezoelectric layer 3001. The first electrode layer 3004 also includes a fifth edge and a sixth edge opposite to the fifth edge in the horizontal direction. The fifth edge has a ramp-down shape, and the sixth edge has a ramp-down shape. The second electrode layer 3006 is disposed at the second side 3003 and contacts the piezoelectric layer 3001. The second electrode layer 3006 also includes a seventh edge and an eighth edge opposite to the seventh edge in the horizontal direction. The seventh edge has a ramp-down shape, and the eighth edge has a ramp-down shape. In the resonance region 3100, the fifth edge corresponds to the seventh edge in the vertical direction, and the sixth edge corresponds to the eighth edge in the vertical direction. The first passivation layer 3008 is disposed at the first side 3002. One part of the first passivation layer 3008 in the resonance region 3100 covers the first electrode layer 3004, and the other part of the first passivation layer 3008 outside the resonance region 3100 also covers the piezoelectric layer 3001 outside the fifth edge and the piezoelectric layer 3001 outside the sixth edge. The second passivation layer 3009 is disposed at the second side 3003. One part of the second passivation layer 3009 in the resonance region 3100 covers the second electrode layer 3006, and the other part of the second passivation layer 3009 outside the resonance region 3100 also covers the piezoelectric layer 3001 outside the seventh edge and the piezoelectric layer 3001 outside the eighth edge. The first overlap layer 3010 is disposed at the first side 3002 and contacts the first passivation layer 3008. The first overlap layer 3010 includes the first raised portion and the first extension portion, and the first raised portion protrudes relative to the first extension portion. The first raised portion is in the resonance region 3100, and overlaps with the first electrode layer 3004 at the fifth edge and the sixth edge. The first raised portion and the first electrode layer 3004 are disposed at two opposite sides of the first passivation layer 3008. The first extension portion is outside the resonance region 3100 and outside the fifth edge and the sixth edge as well, and does not overlap with the first electrode layer 3004. The first extension portion and the piezoelectric layer 3001 are disposed at two opposite sides of the first passivation layer 3008 along the vertical direction. The second overlap layer 3011 is disposed at the second side 3003 and contacts the second passivation layer 3009. The second overlap layer 3011 includes the second raised portion and the second extension portion, and the second raised portion protrudes relative to the second extension portion. The second raised portion is in the resonance region 3100, and overlaps with the second electrode layer 3006 on the seventh edge and the eighth edge. The second raised portion and the second electrode layer 3006 are disposed at two opposite sides of the second passivation layer 3009. The second extension portion is outside the resonance region 3100 and outside the seventh edge and the eighth edge as well, and does not overlap with the second electrode layer 3006. The second extension portion and the piezoelectric layer 3001 are disposed at two opposite sides of the second passivation layer 3009 along the vertical direction.

In some embodiments, an overlap region of the first extension portion, the second extension portion and the piezoelectric layer 3001 forms an evanescent region 3400. A third cutoff frequency of the evanescent region 3400 matches with (for example, equal to or less than) the cutoff frequency of the resonance region 3100.

FIG. 5 illustrates a schematic view of a first top side of the first electrode layer 3004 of the bulk acoustic wave resonance device 3000 relative to the cross-section A according to an embodiment of the present disclosure.

As shown in FIG. 5, the bulk acoustic wave resonance device 3000 includes the first electrode layer 3004 (indicated by a dashed line). The first electrode layer 3004 is hexagonal, including the first edge, the second edge, the fifth edge, the sixth edge, a ninth edge and a tenth edge. The first electrode extension layer 3005 is coupled with the second edge. The first overlap layer 3010 overlaps with a plurality of edges of the first electrode layer 3004 and is adjacent to the first electrode extension layer 3005. The first overlap layer 3010 includes a first raised portion 3015 and a first extension portion 3016. The first raised portion 3015 is disposed at an inner side to the edges of the first electrode layer 3004, and overlaps with the fifth edge, the ninth edge, the first edge, the sixth edge and the tenth edge. The first extension portion 3016 is disposed at an outer side to the fifth edge, the ninth edge, the first edge, the sixth edge and the tenth edge, and does not overlap with the first electrode layer 3004.

In some embodiments, a width w of the first overlap layer 3010 corresponding to each edge is the same. Thus, a width of the first raised portion 3015 corresponding to each edge is the same, and a width of the first extension portion 3016 corresponding to each edge is the same.

In some embodiments, the first passive structure 3012 includes the first overlap layer 3010 adjacent to the first electrode extension layer 3005. In some embodiments, the first passive structure 3012 includes the first raised portion 3015. The first raised portion 3015 overlaps with the fifth edge, the ninth edge, the first edge, the sixth edge and the tenth edge. In some embodiments, the first passive structure 3012 also includes the first extension portion 3016. The first extension portion 3016 is disposed at the outer side to the fifth edge, the ninth edge, the first edge, the sixth edge and the tenth edge, and does not overlap with the first electrode layer 3004.

In some embodiments, a width w of the first passive structure 3012 corresponding to each edge is the same.

FIG. 6 illustrates a schematic structure view of a second top side of the second electrode layer 3006 of the body acoustic wave resonance device 300 relative to the cross-section A.

As shown in FIG. 6, the bulk acoustic wave resonance device 3000 includes the second electrode layer 3006 (indicated by a dashed line). The second electrode layer 3006 is hexagonal, including the third edge, the fourth edge, the seventh edge, the eighth edge, an eleventh edge and a twelfth edge. The second electrode extension layer 3007 is coupled with the third edge. The second overlap layer 3011 overlaps with a plurality of edges of the second electrode layer 3006 and is adjacent to the second electrode extension layer 3007. The second overlap layer 3011 includes the second raised portion 3017 and the second extension portion 3018. The second raised portion 3017 is disposed at an inner side to the edges of the second electrode layer 3006, and overlaps with the seventh edge, the eleventh edge, the fourth edge, the eighth edge and the twelfth edge. The second extension portion 3018 is disposed at an outer side to the seventh edge, the eleventh edge, the fourth edge, the eighth edge and the twelfth edge, and does not overlap with the second electrode layer 3006.

In some embodiments, a width w of the second overlap layer 3011 corresponding to each edge is the same. Thus, a width of the second raised portion 3017 corresponding to each edge is the same, and a width of the second extension portion 3018 corresponding to each edge is the same.

In some embodiments, the second passive structure 3013 includes the second overlap layer 3011 adjacent to the second electrode extension layer 3007. In some embodiments, the second passive structure 3013 includes the second raised portion 3017. The second raised portion 3017 overlaps with the seventh edge, the eleventh edge, the fourth edge, the eighth edge and the twelfth edge. In some embodiments, the second passive structure 3013 further includes the second extension portion 3018. The second extension portion 3018 is disposed at the outer side to the seventh edge, the eleventh edge, the fourth edge, the eighth edge and the twelfth edge, and does not overlap with the second electrode layer 3006.

In some embodiments, a width w of the second passive structure 3013 corresponding to each edge is the same.

In some embodiments, the first passive structure 3012 and the second passive structure 3013 surround the first electrode layer 3004 and the second electrode layer 3006 respectively, that is, surround the resonance region 3100.

It should be noted that in some embodiments, a hexagonal top surface of the electrode layer is a specific embodiment. Therefore, the present disclosure is not limited by the disclosed specific embodiments, and the top surface of the electrode layer can also be other polygons (such as pentagons, heptagons), ellipses, etc.

In other embodiments, the bulk acoustic wave resonance device includes a plurality of electrode extension layers coupled with a plurality of edges of the electrode layer respectively. The passive structure corresponding to the electrode layer is adjacent to the plurality of electrode extension layers, and overlaps with other edges other than the plurality of edges. The passive structure also includes a passive extension portion disposed at an outer side to the other edges.

In some embodiments, the bulk acoustic wave resonance device includes three or more passive structures, and the three or more passive structures surround the resonance region of the bulk acoustic wave resonance device.

FIGS. 11 and 12 illustrate a specific embodiment of a body acoustic wave resonance device of the present disclosure, but the present disclosure can also be implemented in other ways different from the specific embodiments described herein, so the present disclosure is not limited by the specific embodiments disclosed below. FIG. 11 illustrates a schematic structure view of a first cross-section of the body acoustic wave resonance device, and FIG. 12 illustrates a schematic structure view of a second cross-sectional of the body acoustic wave resonance device.

FIG. 11 illustrates a schematic structure view of a cross-section A of a body acoustic wave resonance device 8000.

As shown in FIG. 11, the bulk acoustic wave resonance device 8000 includes a piezoelectric layer 8001, a first electrode layer 8004, a first electrode extension layer 8005, a second electrode layer 8006, a second electrode extension layer 8007, a first passivation layer 8008, a second passivation layer 8009, a first overlap layer 8010 and a second overlap layer 8011. The piezoelectric layer 8001 includes a first side 8002 and a second side 8003 opposite to the first side 8002 in a vertical direction. The first electrode layer 8004 is disposed at the first side 8002 and contacts the piezoelectric layer 8001. The first electrode layer 8004 includes a first edge and a second edge opposite to the first edge in a horizontal direction, and the first edge has a ramp-down shape. The first electrode extension layer 8005 is disposed at the first side 8002. The first electrode extension layer 8005 contacts the piezoelectric layer 8001 and is coupled with the second edge. The second electrode layer 8006 is disposed at the second side 8003 and contacts the piezoelectric layer 8001. The second electrode layer 8006 includes a third edge and a fourth edge opposite to the third edge in the horizontal direction, and the fourth edge has a ramp-down shape. The second electrode extension layer 8007 is disposed at the second side 8003. The second electrode extension layer 8007 contacts the piezoelectric layer 8001 and is coupled with the third edge. An overlap region of the first electrode layer 8004, the second electrode layer 8006 and the piezoelectric layer 8001 forms a resonance region 8100. The first edge corresponds to the third edge in the vertical direction, and the second edge corresponds to the fourth edge in the vertical direction. The first electrode extension layer 8005 and the second electrode extension layer 8007 are disposed outside the resonance region 8100, and there is no overlap portion between the first electrode extension layer 8005 and the second electrode extension layer 8007. The first passivation layer 8008 is disposed at the first side 8002. One part of the first passivation layer 8008 in the resonance region 8100 covers the first electrode layer 8004, and the other part of the first passivation layer 8008 outside the resonance region 3100 covers the first electrode extension layer 8005 outside the second edge. The second passivation layer 8009 is disposed at the second side 8003. One part of the second passivation layer 8009 in the resonance region 8100 covers the second electrode layer 8006, and the other part of the second passivation layer 8009 outside the resonance region 8100 covers the second electrode extension layer 8007 outside the third edge. The first overlap layer 8010 is disposed at the first side 8002 and contacts the first passivation layer 8008. The first overlap layer 8010 includes a first raised portion (not marked) and a first extension portion (not marked). The first raised portion protrudes relative to the first extension portion. The first raised portion is in the resonance region 8100, and overlaps with the first electrode layer 8004 at the first edge. The first raised portion and the first electrode layer 8004 are disposed at two opposite sides of the first passivation layer 8008. The first extension portion is outside the resonance region 8100 and outside the first edge as well, and the first extension portion does not overlap with the first electrode layer 8004. A first gap 8015 is between the first extension portion and the piezoelectric layer 8001. The second overlap layer 8011 is disposed at the second side 8003 and contacts the second passivation layer 8009. The second overlap layer 8011 includes a second raised portion (not marked) and a second extension portion (not marked). The second raised portion protrudes relative to the second extension portion. The second raised portion is in the resonance region 8100, and overlaps with the second electrode layer 8006 at the fourth edge. The second raised portion and the second electrode layer 8006 are disposed at two opposite sides of the second passivation layer 8009. The second extension portion is outside the resonance region 8100 and outside the fourth edge as well, and the second extension portion does not overlap with the second electrode layer 8006. A second gap 8016 is between the second extension portion and the piezoelectric layer 8001.

In some embodiments, the material of the piezoelectric layer 8001 includes, but is not limited to, one of the following: aluminum nitride, aluminum nitride alloy, gallium nitride, zinc oxide, lithium tantalate, lithium niobate, lead zirconate titanate and lead magnesium niobate-lead titanate.

In some embodiments, the piezoelectric layer 8001 is a flat layer. The piezoelectric layer 8001 includes a plurality of crystal grains. The plurality of crystal grains include a first crystal grain and a second crystal grain, and the first crystal grain and the second crystal grain are any two crystal grains of the plurality of crystal grains. It should be understood by those skilled in the art that crystal orientation and crystal plane of a crystal grain can be represented based on a coordinate system.

In some embodiments, the first crystal grain may be represented based on a first stereoscopic coordinate system, and the second crystal grain may be represented based on a second stereoscopic coordinate system. The first stereoscopic coordinate system includes at least a first coordinate axis along a first direction and a third coordinate axis along a third direction, and the second stereoscopic coordinate system includes at least a second coordinate axis along a second direction and a fourth coordinate axis along a fourth direction. The first coordinate axis corresponds to a height of the first crystal grain, and the second coordinate axis corresponds to a height of the second crystal grain.

In some embodiments, the first direction is the same as or opposite to the second direction. It should be noted that the first direction being the same as the second direction means that an included angle between a vector along the first direction and a vector along the second direction ranges from 0 degree to 5 degrees, and the first direction being opposite to the second direction means that the included angle between the vector along the first direction and the vector along the second direction ranges from 175 degrees to 180 degrees.

In some embodiments, the first stereoscopic coordinate system is an ac stereoscopic coordinate system, wherein the first coordinate axis is a first c-axis and the third coordinate axis is a first a-axis. The second stereoscopic coordinate system is an ac stereoscopic coordinate system, wherein the second coordinate axis is a second c-axis, and the fourth coordinate axis is a second a-axis. The first c-axis and the second c-axis have the same or opposite orientation.

In some embodiments, the first stereoscopic coordinate system further includes a fifth coordinate axis along a fifth direction and the second stereoscopic coordinate system further includes a sixth coordinate axis along a sixth direction. In some embodiments, the first direction is the same as or opposite to the second direction, and the third direction is the same as or opposite to the fourth direction. It should be noted that the third direction being the same as the fourth direction means that an included angle between a vector along the third direction and a vector along the fourth direction ranges from 0 degree to 5 degrees, and the third direction being opposite to the fourth direction means that the included angle between the vector along the third direction and the vector along the fourth direction ranges from 175 degrees to 180 degrees.

In some embodiments, the first stereoscopic coordinate system is an xyz stereoscopic coordinate system, wherein the first coordinate axis is a first z-axis, the third coordinate axis is a first y-axis, and the fifth coordinate axis is a first x-axis. The second stereoscopic coordinate system is an xyz stereoscopic coordinate system, wherein the second coordinate axis is a second z-axis, the fourth coordinate axis is a second y-axis, and the sixth coordinate axis is a second x-axis. In some embodiments, the first z-axis and the second z-axis have the same orientation, and the first y-axis and the second y-axis have the same orientation. In some embodiments, the first z-axis and the second z-axis have opposite orientation, and the first y-axis and the second y-axis have opposite orientation. In some embodiments, the first z-axis and the second z-axis have the same orientation, and the first y-axis and the second y-axis have opposite orientation. In some embodiments, the first z-axis and the second z-axis have opposite orientation, and the first y-axis and the second y-axis have the same orientation.

In some embodiments, the piezoelectric layer 8001 includes a plurality of crystal grains and a crystal composed of the plurality of crystal grains has a full width at half maximum of rocking curve less than 2.5 degrees.

In some embodiments, the material of the first electrode layer 8004 includes, but is not limited to, at least one of the following: molybdenum, ruthenium, tungsten, platinum, iridium, aluminum and beryllium, and the material of the first electrode extension layer 8005 includes, but is not limited to, at least one of the following: molybdenum, ruthenium, tungsten, platinum, iridium, aluminum, beryllium, copper and gold. In some embodiments, the material of the first electrode layer 8004 is the same as that of the first electrode extension layer 8005.

In some embodiments, the material of the second electrode layer 8006 includes, but is not limited to, at least one of the following: molybdenum, ruthenium, tungsten, platinum, iridium, aluminum and beryllium, and the material of the second electrode extension layer 8007 includes, but is not limited to, at least one of the following: molybdenum, ruthenium, tungsten, platinum, iridium, aluminum, beryllium, copper and gold. In some embodiments, the material of the first electrode layer 8006 may be the same as that of the first electrode extension layer 8007.

In some embodiments, the material of the electrode layer may be different from that of the electrode extension layer.

In some embodiments, the material of the first passivation layer 8008 includes, but is not limited to, one of the following: silicon dioxide, silicon oxynitride, silicon oxycarbide, silicon nitride, titanium oxide, aluminium oxide, hafnium silicate, zirconium silicate, hafnium dioxide, and zirconium dioxide. In some embodiments, the material of the second passivation layer 8009 includes, but is not limited to one of the following: silicon dioxide, silicon oxynitride, silicon oxycarbide, silicon nitride, titanium oxide, aluminium oxide, hafnium silicate, zirconium silicate, hafnium dioxide, and zirconium dioxide. In some embodiments, the material of the first passivation layer 8008 may be the same as that of the second passivation layer 8009. In other embodiments, the material of the first passivation layer (e.g., the first passivation layer 8008) may be different from that of the second passivation layer (e.g., the second passivation layer 8009).

In some embodiments, the material of the first overlap layer 8010 includes, but is not limited to, at least one of the following: molybdenum, ruthenium, tungsten, platinum, iridium, aluminum and beryllium. In some embodiments, the material of the first overlap layer 8010 may be the same as that of the first electrode layer 8004.

In some embodiments, the material of the second overlap layer 8011 includes, but is not limited to, at least one of the following: molybdenum, ruthenium, tungsten, platinum, iridium, aluminum and beryllium. In some embodiments, the material of the second overlap layer 8011 may be the same as that of the second electrode layer 8006.

In other embodiments, the material of the overlap layer may be different from that of the electrode layer, for example, the material of the overlap layer is tungsten or platinum, and the material of the electrode layer is molybdenum.

In some embodiments, the overlap layer includes a first overlap sub-layer and a second overlap sub-layer. The first overlap sub-layer contacts the passivation layer, the second overlap sub-layer contacts the first overlap sub-layer, and the second overlap sub-layer and the passivation layer are disposed at two opposite sides of the first overlap sub-layer. The material of the first overlap sub-layer may be different from that of the second overlap sub-layer, for example, the material of the first overlap sub-layer is molybdenum, and the material of the second overlap sub-layer is platinum or tungsten.

In some embodiments, the bulk acoustic wave resonance device 8000 further includes a first passive structure 8012 and a second passive structure 8013. The first passive structure 8012 is disposed at the first side 8002 and contacts the first edge of the first electrode layer 8004. The first passive structure 8012 includes the first overlap layer 8010, a first dielectric portion (not marked) that is a part of the first passivation layer 8008 overlapping with the first overlap layer 8010, and the first gap 8015. The second passive structure 8013 is disposed at the second side 8003 and contacts the fourth edge of the second electrode layer 8006. The second passive structure 8013 includes the second overlap layer 8011, a second dielectric portion (not marked) that is a part of the second passivation layer 8009 overlapping with the second overlap layer 8011, and the second gap 8016. It should be noted that the dielectric portions can electrically isolate the overlap layers from the electrode layers, so that the electrode layers and the overlap layers are not electrically coupled, thus the overlap layers are passive, and thus a combination structure of the dielectric portion and the overlap layer is also passive.

In some embodiments, a first thickness of the first passive structure 8012 is less than a thickness of the first electrode layer 8004, a second thickness of the second passive structure 8013 is less than a thickness of the second electrode layer 8006, and the first thickness is equal to or approximately equal to the second thickness.

In some embodiments, a first width of the first raised portion matches with a wavelength of major-mode transverse acoustic waves generated in the resonance region 8100 (for example, the first width is an integer multiple of half the wavelength). A second width of the second raised portion matches with the wavelength of the major-mode transverse acoustic waves generated in the resonance region 8100 (for example, the second width is equal to an integer multiple of half the wavelength), and the first width is equal to or approximately equal to the second width. It should be noted that the first raised portion and the second raised portion are used to make acoustic impedance matching of the resonance region and the evanescent region, so that more acoustic waves generated in the resonance region can propagate into the evanescent region.

In some embodiments, a third thickness of the first extension portion is less than the thickness of the first electrode layer 8004, a fourth thickness of the second extension portion is less than the thickness of the second electrode layer 8006, and the third thickness is equal to or approximately equal to the fourth thickness.

In some embodiments, an overlap region of the first extension portion, the second electrode extension layer 8007 and the piezoelectric layer 8001 forms an evanescent region 8200, and an overlap region of the second extension portion, the first electrode extension layer 8005 and the piezoelectric layer 8001 forms an evanescent region 8300. A first cutoff frequency of the evanescent region 8200 matches with (for example, equal to or less than) a cutoff frequency of the resonance region 8100, a second cutoff frequency of the evanescent region 8300 matches with (for example, equal to or less than) the cutoff frequency of the resonance region 8100, and the first cutoff frequency is equal to or approximately equal to the second cutoff frequency.

It should be noted that the cutoff frequency of the evanescent region matches with the cutoff frequency of the resonance region, which results in the acoustic waves entering the evanescent region are in the evanescent mode, that is, the wave number in the evanescent region only includes an imaginary part, resulting in exponential decay of the acoustic waves. It should be noted that the passive structures can decay the transverse acoustic waves generated in the resonance region so as to suppress lateral spurious mode to improve Zₚ and corresponding Q value. In addition, the passive structures are not electrically coupled with the electrode layers, thus the impact of the passive structures on Kt² is relatively small.

In some embodiments, the bulk acoustic wave resonance device 8000 further includes a cavity 8014. The first electrode layer 8004 is disposed in the cavity 8014, one end of the first electrode extension layer 8005 is disposed in the cavity 8014, and the first passive structure 8012 is disposed in the cavity 8014. In other embodiments, a lower electrode layer (i.e., the first electrode layer 8004) may be disposed above the cavity and cover the cavity. The passive structure corresponding to the lower electrode layer is disposed outside the cavity.

FIG. 12 illustrates a schematic structure view of a cross-section B of the bulk acoustic wave resonance device 8000 according to an embodiment of the present disclosure.

As shown in FIG. 12, the bulk acoustic wave resonance device 8000 includes the piezoelectric layer 8001, the first electrode layer 8004, the second electrode layer 8006, the first passivation layer 8008, the second passivation layer 8009, the first overlap layer 8010 and the second overlap layer 8011. The piezoelectric layer 8001 includes the first side 8002 and the second side 8003. The first electrode layer 8004 is disposed at the first side 8002 and contacts the piezoelectric layer 8001. The first electrode layer 8004 also includes a fifth edge and a sixth edge opposite to the fifth edge in the horizontal direction. The fifth edge has a ramp-down shape, and the sixth edge has a ramp-down shape. The second electrode layer 8006 is disposed at the second side 8003 and contacts the piezoelectric layer 8001. The second electrode layer 8006 also includes a seventh edge and an eighth edge opposite to the seventh edge in the horizontal direction. The seventh edge has a ramp-down shape, and the eighth edge has a ramp-down shape. In the resonance region 8100, the fifth edge corresponds to the seventh edge in the vertical direction, and the sixth edge corresponds to the eighth edge in the vertical direction. The first passivation layer 8008 is disposed at the first side 8002. One part of the first passivation layer 8008 in the resonance region 8100 covers the first electrode layer 8004. The second passivation layer 8009 is disposed at the second side 8003. One part of the second passivation layer 8009 in the resonance region 8100 covers the second electrode layer 8006. The first overlap layer 8010 is disposed at the first side 8002 and contacts the first passivation layer 8008. The first overlap layer 8010 includes the first raised portion (not marked) and the first extension portion (not marked), and the first raised portion protrudes relative to the first extension portion. The first raised portion is in the resonance region 8100, and overlaps with the first electrode layer 8004 at the fifth edge and the sixth edge. The first raised portion and the first electrode layer 8004 are disposed at two opposite sides of the first passivation layer 8008, and the first extension portion is outside the resonance region 8100 and outside the fifth edge and the sixth edge as well. The first extension portion does not overlap with the first electrode layer 8004, and the first gap 8015 is between the first extension portion and the piezoelectric layer 8001. The second overlap layer 8011 is disposed at the second side 8003 and contacts the second passivation layer 8009. The second overlap layer 8011 includes the second raised portion (not marked) and the second extension portion (not marked), and the second raised portion protrudes relative to the second extension portion. The second raised portion is in the resonance region 8100, and overlaps with the second electrode layer 8006 at the seventh edge and the eighth edge. The second raised portion and the second electrode layer 8006 are disposed at two opposite sides of the second passivation layer 8009, and the second extension portion is outside the resonance region 8100 and outside the seventh edge and the eighth edge as well. The second extension portion does not overlap with the second electrode layer 8006, and the second gap 8016 is between the second extension portion and the piezoelectric layer 8001.

In some embodiments, an overlap region of the first extension portion, the second extension portion and the piezoelectric layer 8001 forms an evanescent region 8400. A third cutoff frequency of the evanescent region 8400 matches with (for example, equal to or less than) the cutoff frequency of the resonance region 8100.

In some embodiments, the bulk acoustic wave resonance device includes a piezoelectric layer, a first electrode layer, a first electrode extension layer, a second electrode layer, a second electrode extension layer, a first overlap layer and a second overlap layer. The piezoelectric layer includes a first side and a second side opposite to the first side along a vertical direction. The first electrode layer is disposed at the first side and contacts the piezoelectric layer. The first electrode layer includes a first edge and a second edge opposite to the first edge in a horizontal direction, and the first edge has a ramp-down shape. The first electrode extension layer is disposed at the first side. The first electrode extension layer contacts the piezoelectric layer and is coupled with the second edge. The second electrode layer is disposed at the second side and contacts the piezoelectric layer. The second electrode layer includes a third edge and a fourth edge opposite to the third edge in the horizontal direction, and the fourth edge has a ramp-down shape. The second electrode extension layer is disposed at the second side. The second electrode extension layer contacts the piezoelectric layer and is coupled with the third edge. An overlap region of the first electrode layer, the second electrode layer and the piezoelectric layer forms a resonance region. The first edge corresponds to the third edge along the vertical direction, and the second edge corresponds to the fourth edge along the vertical direction. The first electrode extension layer and the second electrode extension layer are outside the resonance region, and do not overlap with each other. The first overlap layer is disposed at the first side and contacts the piezoelectric layer. The first overlap layer includes a first raised portion and a first extension portion. The first raised portion protrudes relative to the first extension portion. The first raised portion is in the resonance region, and overlaps with the first electrode layer at the first edge. A first dielectric portion is disposed between the first raised portion and the first electrode layer, such as vacuum, air and helium. The first extension portion is outside the resonance region and outside the first edge as well. The first extension portion does not overlap with the first electrode layer, and the first extension portion contacts the piezoelectric layer. The second overlap layer is disposed at the second side and contacts the piezoelectric layer. The second overlap layer includes a second raised portion and a second extension portion. The second raised portion protrudes relative to the second extension portion. The second raised portion is in the resonance region, and overlaps with the second electrode layer at the fourth edge. A second dielectric portion is disposed between the second raised portion and the second electrode layer, such as vacuum, air and helium. The second extension portion is outside the resonance region and outside the fourth edge as well. The second extension portion does not overlap with the second electrode layer, and the second extension portion contacts the piezoelectric layer.

In some embodiments, the bulk acoustic wave resonance device further includes a first passive structure and a second passive structure. The first passive structure is disposed at the first side and contacts the piezoelectric layer. The first passive structure includes the first overlap layer and the first dielectric portion. The second passive structure is disposed at the second side and contacts the piezoelectric layer. The second passive structure includes the second overlap layer and the second dielectric portion. It should be noted that the dielectric portion can electrically isolate the overlap layers from the electrode layers, so that the overlap layers are passive.

In some embodiments, an overlap region of the first extension portion, the second electrode extension layer and the piezoelectric layer forms a first evanescent region, and an overlap region of the second extension portion, the first electrode extension layer and the piezoelectric layer forms a second evanescent region. A first cutoff frequency of the first evanescent region matches with (for example, equal to or less than) a cutoff frequency of the resonance region, a second cutoff frequency of the second evanescent region matches with (for example, equal to or less than) the cutoff frequency of the resonance region, and the first cutoff frequency is equal to or approximately equal to the second cutoff frequency.

It should be noted that the cutoff frequency of the evanescent region matches with the cutoff frequency of the resonance region, which results in the acoustic waves entering the evanescent region are in the evanescent mode, that is, the wave number in the evanescent region only includes an imaginary part, resulting in exponential decay of the acoustic waves. It should be noted that the passive structures can decay the transverse acoustic waves generated in the resonance region so as to suppress lateral spurious mode to improve Zₚ and corresponding Q value. In addition, the passive structures are not electrically coupled with the electrode layers, thus the impact of the passive structures on Kt² is relatively small.

FIG. 13 illustrates a schematic structural view of a wireless communication device 900. As shown in FIG. 13, the wireless communication device 900 includes an RF front-end device 910, a baseband processing device 930 and an antenna 950. A first end of the RF front-end device 910 is coupled with the baseband processing device 930, and a second end of the RF front-end device 910 is coupled with the antenna 950. The RF front-end device 910 includes a first filtering device 911, a second filtering device 913, a multiplexing device 915, a power amplification device 917 and a low noise amplification device 919. The first filtering device 911 is coupled with the power amplification device 917, and the second filtering device 913 is electrically coupled with the low noise amplification device 919. The multiplexing device 915 includes at least one transmitting filtering device (not shown) and at least one receiving filtering device (not shown). The first filtering device 911 includes at least one bulk acoustic wave resonance device according to any one of preceding embodiments, and the second filtering device 913 includes at least one bulk acoustic wave resonance device according to any one of preceding embodiments. The at least one transmitting filtering device includes at least one bulk acoustic wave resonance device according to any one of preceding embodiments, or the at least one receiving filtering device includes at least one bulk acoustic wave resonance device according to any one of preceding embodiments.

FIG. 14 illustrates a method for forming a bulk acoustic wave resonance device according to a specific embodiment of the present disclosure. However, the present disclosure can also be implemented in other ways different from the specific embodiment described herein, so the present disclosure is not limited by the specific embodiment disclosed below.

FIG. 14 illustrates a flowchart of a method 1000 for forming a bulk acoustic wave resonance device according to an embodiment of the present disclosure.

Another embodiment of the present disclosure provides a method for forming a bulk acoustic wave resonance device. The method includes steps of:
S1001: forming a piezoelectric layer, wherein the piezoelectric layer includes a first side and a second side opposite to the first side in a vertical direction; forming a first electrode layer at the first side, wherein the first electrode layer contacts the piezoelectric layer; forming a second electrode layer at the second side, wherein the second electrode layer contacts the piezoelectric layer, and an overlap region of the first electrode layer, the second electrode layer and the piezoelectric layer forms a resonance region.
S1003: forming a first passive structure at the first side, wherein the first passive structure has a first overlap portion overlapping with at least one edge of the first electrode layer; wherein the first passive structure includes a first raised portion, a first dielectric portion and a first extension portion, and the first raised portion protrudes relative to the first extension portion; wherein the first raised portion is disposed in the resonance region and has the first overlap portion overlapping with the at least one edge of the first electrode layer, and the first raised portion is configured to make acoustic impedance matching of the resonance region and at least one evanescent region disposed outside the resonance region, so that more acoustic waves generated in the resonance region enter the at least one evanescent region; wherein the first dielectric portion is disposed between the first raised portion and the first electrode layer for electrically isolating the first passive structure from the first electrode layer; wherein the first extension portion is disposed outside the resonance region and in the at least one evanescent region for decaying the acoustic waves entering the at least one evanescent region.
S1005: forming a second passive structure at the second side, wherein the second passive structure has a second overlap portion overlapping with at least one edge of the second electrode layer; wherein the second passive structure includes a second raised portion, a second dielectric portion and a second extension portion, and the second raised portion protrudes relative to the second extension portion; wherein the second raised portion is disposed in the resonance region and has the second overlap portion overlapping with the at least one edge of the second electrode layer, and the second raised portion is configured to make acoustic impedance matching of the resonance region and the at least one evanescent region, so that more acoustic waves generated in the resonance region enter the at least one evanescent region; wherein the second dielectric portion is disposed between the second raised portion and the second electrode layer for electrically isolating the second passive structure from the second electrode layer; wherein the second extension portion is disposed outside the resonance region and in the at least one evanescent region for decaying the acoustic waves entering the at least one evanescent region.

In some embodiments, the first passive structure and the second passive structure surround the resonance region.

In some embodiments, a thickness of the first passive structure is equal to or less than a thickness of the first electrode layer, and a thickness of the second passive structure is equal to or less than a thickness of the second electrode layer.

In some embodiments, forming the first electrode layer includes forming at least one edge, corresponding to the first passive structure, having a ramp-down shape, and forming the second electrode layer includes forming at least one edge, corresponding to the second passive structure, having a ramp-down shape.

In some embodiments, forming the first passive structure includes: forming a first passivation layer at the first side covering the first electrode layer; and forming a first overlap layer contacting the first passivation layer and having the first overlap portion overlapping with the at least one edge of the first electrode layer; wherein the first passivation layer includes the first dielectric portion, and the first overlap layer includes the first raised portion and the first extension portion.

In some embodiments, forming the second passive structure includes: forming a second passivation layer at the second side covering the second electrode layer; and forming a second overlap layer contacting the second passivation layer and having the second overlap portion overlapping with the at least one edge of the second electrode layer; wherein the second passivation layer includes the second dielectric portion, and the second overlap layer includes the second raised portion and the second extension portion.

In some embodiments, a thickness of the first extension portion is less than a thickness of the first electrode layer, and a thickness of the second extension portion is less than a thickness of the second electrode layer.

In some embodiments, the at least one evanescent region includes a first evanescent region having a first cutoff frequency equal to or less than a cutoff frequency of the resonance region, and the first evanescent region corresponds to an overlap region of the first extension portion, the piezoelectric layer and the second extension portion.

In some embodiments, the method further includes: forming a first electrode extension layer at the first side and forming a second electrode extension layer at the second side. The first electrode extension layer is coupled with the first electrode layer, and the second electrode extension layer is coupled with the second electrode layer.

In some embodiments, the at least one evanescent region includes a second evanescent region having a second cutoff frequency equal to or less than a cutoff frequency of the resonance region, and the second evanescent region corresponds to an overlap region of the second electrode extension layer, the piezoelectric layer and the first extension portion.

In some embodiments, the at least one evanescent region includes a third evanescent region having a third cutoff frequency equal to or less than a cutoff frequency of the resonance region, and the third evanescent region corresponds to an overlap region of the second extension portion, the piezoelectric layer and the first electrode extension layer.

In some embodiments, a width of the first raised portion is an integer multiple of a half wavelength of the acoustic waves generated in the resonance region, and a width of the second raised portion is an integer multiple of the half wavelength of the acoustic waves generated in the resonance region.

In some embodiments, forming the first overlap layer includes forming a first overlap sub-layer and a second overlap sub-layer. The second overlap sub-layer and the piezoelectric layer are disposed at two opposite sides of the first overlap sub-layer, and a material of the first overlap sub-layer is different from a material of the second overlap sub-layer.

In some embodiments, forming the second overlap layer includes forming a third overlap sub-layer and a fourth overlap sub-layer. The fourth overlap sub-layer and the piezoelectric layer are disposed at two opposite sides of the third overlap sub-layer, and a material of the third overlap sub-layer is different from a material of the fourth overlap sub-layer.

In some embodiments, the method further includes: forming a first sacrificial layer between the first extension portion and the piezoelectric layer; and forming a second sacrificial layer between the second extension portion and the piezoelectric layer.

In some embodiments, the method further includes: removing the first sacrificial layer to form a first gap between the first extension portion and the piezoelectric layer; and removing the second sacrificial layer to form a second gap between the second extension portion and the piezoelectric layer.

In some embodiments, the first dielectric portion is further disposed between the piezoelectric layer and the first extension portion, and the second dielectric portion is further disposed between the piezoelectric layer and the second extension portion.

It should be noted that the raised portions of the passive structures are in the resonance region and have overlap portions overlapping with the electrode layers respectively, which can match the acoustic impedance of the resonance region with the acoustic impedance of the evanescent region outside the resonance region, so that more acoustic waves generated in the resonance region can propagate into the evanescent region. In addition, the cutoff frequency of the evanescent region matches with (for example, equal to or less than) the cutoff frequency of the resonance region, which can decay the acoustic waves entering the evanescent region, so as to suppress lateral spurious mode to improve Zₚ and corresponding Q value. The cutoff frequency is a frequency corresponding to a wave number of 0 on a dispersion curve. In addition, the passive structures are not electrically coupled with the electrode layers, so that the impact of the passive structures on Kt² is relatively small.

FIGS. 15 to 18 illustrate specific embodiments of a method for forming a bulk acoustic wave resonance device of the present disclosure, but the present disclosure can also be implemented in other ways different from the specific embodiments described herein, so the present disclosure is not limited by the specific embodiments disclosed below.

FIGS. 15 to 18 illustrate schematic structural views of a section A during a method for forming a bulk acoustic wave resonance device 1100 according to an embodiment of the present disclosure.

As shown in FIG. 15, the method for forming the bulk acoustic wave resonance device 1100 includes: forming a piezoelectric layer 1101, wherein the piezoelectric layer 1101 includes a first side 1102 and a second side 1103 opposite to the first side 1102 in a vertical direction; forming a first electrode layer 1104 at the first side, wherein the first electrode layer 1104 contacts the piezoelectric layer 1101 and includes a first edge and a second edge opposite to the first edge in a horizontal direction; and forming a first electrode extension layer 1105 at the first side 1102, wherein the first electrode extension layer 1105 contacts the piezoelectric layer 1101 and is coupled with the second edge.

In some embodiments, the method for forming the bulk acoustic wave resonance device 1100 further includes: providing a first substrate (not shown) before forming the piezoelectric layer 1101. In some embodiments, the piezoelectric layer 1101 is formed at one side of the first substrate, and the first substrate is disposed at the second side 1103.

In some embodiments, forming the first electrode layer 1104 includes: forming a first ramp-down edge at the first edge.

As shown in FIG. 16, the method for forming the bulk acoustic wave resonance device 1100 further includes: forming a first passivation layer 1106 at the first side 1102, wherein the first passivation layer 1106 covers the first electrode layer 1104, covers the piezoelectric layer 1101 outside the first edge, and also covers the first electrode extension layer 1105 outside the second edge; forming a first overlap layer 1107 at the first side 1102 and contacting the first passivation layer 1106, wherein the first overlap layer 1107 includes a first raised portion (not marked) and a first extension portion (not marked), and the first raised portion protrudes relative to the first extension portion. The first raised portion is disposed at an inner side to the first edge and has an overlap portion overlapping with the first electrode layer 1104 at the first edge. The first raised portion and the first electrode layer 1104 are disposed at two opposite sides of the first passivation layer 1106. The first extension portion is outside the first edge, and does not overlap with the first electrode layer 1104. The first extension portion and the piezoelectric layer 1101 are disposed at two opposite sides of the first passivation layer 1106 along the vertical direction.

In some embodiments, the method for forming the bulk acoustic wave resonance device 1100 further includes: forming a sacrificial layer 1108 at the first side 1102. The sacrificial layer 1108 covers the first electrode layer 1104, one end of the electrode extension layer 1105 coupled with the second edge, and the first overlap layer 1107. The first passivation layer 1106 is disposed between the first electrode layer 1104 and the sacrificial layer 1108, and between the first electrode extension layer 1105 and the sacrificial layer 1108 as well.

In some embodiments, the method for forming the bulk acoustic wave resonance device 1100 further includes: forming a first connecting layer (not shown) at the first side 1102. The first connecting layer covers the sacrificial layer 1108 and the first passivation layer 1106.

In some embodiments, the method for forming the bulk acoustic wave resonance device 1100 further includes: forming a sacrificial layer overlapping with a lower electrode layer (i.e., the first electrode layer 1104), wherein a passivation layer is disposed between the sacrificial layer and the lower electrode layer, a lower overlap layer corresponding to the lower electrode layer is disposed at a first side of the sacrificial layer in the horizontal direction, and a lower electrode extension layer is disposed at a second side of the sacrificial layer in the horizontal direction; and forming a connecting layer covering the sacrificial layer and the passivation layer.

In some embodiments, the method for forming the bulk acoustic wave resonance device 1100 further includes: providing a second substrate (not shown); forming a second connecting layer (not shown) at one side of the second substrate and covering the second substrate; connecting the first connecting layer with the second connecting layer to form an intermediate layer (not shown), wherein the second substrate and the intermediate layer are disposed at the first side 1102; and removing the first substrate. In some embodiments, connecting the first connecting layer with the second connecting layer includes bonding the first connecting layer with the second connecting layer or adhering the first connecting layer to the second connecting layer.

As shown in FIG. 17, the method for forming the bulk acoustic wave resonance device 1100 further includes: forming a second electrode layer 1109 at the second side 1103 and contacting the piezoelectric layer 1101; and forming a second electrode extension layer 1110 at the second side 1103 and contacting the piezoelectric layer 1101.The second electrode layer 1109 includes a third edge and a fourth edge opposite to the third edge in the horizontal direction. The second electrode extension layer 1110 is coupled with the third edge of the second electrode layer 1109. The third edge corresponds to the first edge in the vertical direction, and the fourth edge corresponds to the second edge in the vertical direction.

In some embodiments, forming the second electrode layer 1109 includes forming a second ramp-down edge at the fourth edge.

As shown in FIG. 18, the method for forming the bulk acoustic wave resonance device 1100 further includes: forming a second passivation layer 1111 at the second side 1103, wherein the second passivation layer 1111 covers the second electrode layer 1109, covers the piezoelectric layer 1101 outside the fourth edge, and covers the second electrode extension layer 1110 outside the third edge; forming a second overlap layer 1112 at the second side 1103 and contacting the second passivation layer 1111. The second overlap layer 1112 includes a second raised portion (not marked) and a second extension portion (not marked), and the second raised portion protrudes relative to the second extension portion. The second raised portion is disposed at an inner side to the fourth edge and overlaps with the second electrode layer 1109 at the fourth edge. The second raised portion and the second electrode layer 1109 are disposed at two opposite sides of the second passivation layer 1111. The second extension portion is outside the fourth edge, and does not overlap with the second electrode layer 1109. The second extension portion and the piezoelectric layer 1101 are disposed at two opposite sides of the second passivation layer 1111 along the vertical direction.

In some embodiments, the method for forming the bulk acoustic wave resonance device 1100 further includes: removing the sacrificial layer 1108 to form a cavity 1113. The first electrode layer 1104, one end of the first electrode extension layer 1105 coupled with the second edge and the first overlap layer 1107 are disposed in the cavity 1113.

In some embodiments, the first overlap layer 1107 and the first dielectric portion (not marked) that is a part of the first passivation layer 1106 overlapping with the first overlap layer 1107 form a first passive structure 1114. The first passive structure 1114 is disposed at the first side 1102 and contacts the first edge of the first electrode layer 1104 and the piezoelectric layer 1101 outside the first edge. The second overlap layer 1112 and the second dielectric portion (not marked) that is a part of the second passivation layer 1111 overlapping with the second overlap layer 1112 form a second passive structure 1115. The second passive structure 1115 is disposed at the second side 1103 and contacts the fourth edge of the second electrode layer 1109 and the piezoelectric layer 1101 outside the fourth edge. It should be noted that the dielectric portions can electrically isolate the overlap layers from the electrode layers, so that the electrode layers and the overlap layers are not electrically coupled, thus the overlap layers are passive, and thus a combination structure of the dielectric portion and the overlap layer is also passive.

In some embodiments, a first thickness of the first passive structure 1114 is less than a thickness of the first electrode layer 1104, a second thickness of the second passive structure 1115 is less than a thickness of the second electrode layer 1109, and the first thickness is equal to or approximately equal to the second thickness.

In some embodiments, an overlap region of the first electrode layer 1104, the second electrode layer 1109 and the piezoelectric layer 1101 forms a resonance region 1120, an overlap region of the first extension portion, the second electrode extension layer 1110, and the piezoelectric layer 1101 form an evanescent region 1130, and an overlap region of the second extension portion, the first electrode extension layer 1105 and the piezoelectric layer 1101 form an evanescent region 1140. A first cutoff frequency of the evanescent region 1130 matches with (for example, equal to or less than) a cutoff frequency of the resonance region 1120, a second cutoff frequency of the evanescent region 1140 matches with (for example, equal to or less than) the cutoff frequency of the resonance region 1120, and the first cutoff frequency is equal to or approximately equal to the second cutoff frequency.

In some embodiments, a first width of the first raised portion matches with a wavelength of major-mode transverse acoustic waves generated in the resonance region, such as Rayleigh-Lamb 1st order mode or 1st order Thickness Extension mode. For example, the first width is an integer multiple of half the wavelength. A second width of the second raised portion matches with the wavelength of the major-mode transverse acoustic waves generated in the resonance region. For example, the second width is equal to an integer multiple of half the wavelength, and the first width is equal to or approximately equal to the second width. It should be noted that the first raised portion and the second raised portion are used to make acoustic impedance matching of the resonance region and the evanescent region, so that more acoustic waves generated in the resonance region can propagate into the evanescent region.

In some embodiments, a third thickness of the first extension portion is less than the thickness of the first electrode layer 1104, a fourth thickness of the second extension portion is less than the thickness of the second electrode layer 1109, and the third thickness is equal to or approximately equal to the fourth thickness.

It should be noted that the cutoff frequency of the evanescent region matches with the cutoff frequency of the resonance region, which can result in the acoustic waves entering the evanescent region are in the evanescent mode, that is, the wave number in the evanescent region only includes an imaginary part, resulting in exponential decay of the acoustic waves. It should be noted that the passive structures can decay the transverse acoustic waves generated in the resonance region, so as to suppress lateral spurious mode to improve Zₚ and corresponding Q value. In addition, the passive structures are not electrically coupled with the electrode layers, thus the impact of the passive structures on Kt² is relatively small.

In some embodiments, forming the overlap layer includes forming a first overlap sub-layer contacting the passivation layer, and forming a second overlap sub-layer contacting the first overlap sub-layer. The second overlap sub-layer and the passivation layer are disposed at two opposite sides of the first overlap sub-layer. The material of the first overlap sub-layer may be different from that of the second overlap sub-layer, for example, the material of the first overlap sub-layer is molybdenum, and the material of the second overlap sub-layer is platinum or tungsten.

FIGS. 19 to 22 illustrate specific embodiments of a method for forming a bulk acoustic wave resonance device of the present disclosure, but the present disclosure can also be implemented in other ways different from the present disclosure described herein, thus the present disclosure is not limited by the specific embodiments disclosed below.

FIGS. 19 to 22 illustrate schematic structural views of a section A during a method for forming a bulk acoustic wave resonance device 1200 according to an embodiment of the present disclosure.

As shown in FIG. 19, the method for forming the bulk acoustic wave resonance device 1200 includes: forming a piezoelectric layer 1201, wherein the piezoelectric layer 1201 includes a first side 1202 and a second side 1203 opposite to the first side 1202 in a vertical direction; forming a first electrode layer 1204 at the first side, wherein the first electrode layer 1204 contacts the piezoelectric layer 1201 and includes a first edge and a second edge opposite to the first edge in a horizontal direction; and forming a first electrode extension layer 1205 at the first side 1202, wherein the first electrode extension layer 1205 contacts the piezoelectric layer 1201 and is coupled with the second edge.

In some embodiments, the method for forming the bulk acoustic wave resonance device 1200 further includes: providing a first substrate (not shown) before forming the piezoelectric layer 1201. In some embodiments, the piezoelectric layer 1201 is formed at one side of the first substrate, and the first substrate is disposed at the second side 1203.

In some embodiments, forming the first electrode layer 1204 includes: forming a first ramp-down edge at the first edge.

As shown in FIG. 20, the method for forming the bulk acoustic wave resonance device 1200 further includes: forming a first passivation layer 1206 at the first side 1202, wherein the first passivation layer 1206 covers the first electrode layer 1204, and also covers the first electrode extension layer 1205 outside the second edge; forming a first sacrificial layer 1207 at the first side 1202, wherein the first sacrificial layer 1207 is outside the first edge and contacts the piezoelectric layer 1201 and the first passivation layer 1206; forming a first overlap layer 1208 at the first side 1202, wherein the first overlap layer 1208 contacts the first passivation layer 1206 and the first sacrificial layer 1207, wherein the first overlap layer 1208 includes a first raised portion (not marked) and a first extension portion (not marked), and the first raised portion protrudes relative to the first extension portion. The first raised portion is disposed at an inner side to the first edge and overlaps with the first electrode layer 1204 at the first edge. The first raised portion and the first electrode layer 1204 are disposed at two opposite sides of the first passivation layer 1206. The first extension portion is outside the first edge, and does not overlap with the first electrode layer 1204. The first extension portion and the piezoelectric layer 1201 are disposed at two opposite sides of the first sacrificial layer 1207 along the vertical direction.

In some embodiments, the method for forming the bulk acoustic wave resonance device 1200 further includes: forming a second sacrificial layer 1209 at the first side 1202. The second sacrificial layer 1209 covers the first electrode layer 1204, one end of the first electrode extension layer 1205 coupled with the second edge, and the first sacrificial layer 1207 and the first overlap layer 1208. The first passivation layer 1206 is disposed between the first electrode layer 1204 and the second sacrificial layer 1209, and between the first electrode extension layer 1205 and the second sacrificial layer 1209.

In some embodiments, the method for forming the bulk acoustic wave resonance device 1200 further includes: forming a first connecting layer (not shown) at the first side 1202. The first connecting layer covers the second sacrificial layer 1209 and the piezoelectric layer 1201.

In some embodiments, the method for forming the bulk acoustic wave resonance device 1200 further includes: providing a second substrate (not shown); forming a second connecting layer (not shown) at one side of the second substrate and covering the second substrate; connecting the first connecting layer with the second connecting layer to form an intermediate layer (not shown), wherein the second substrate and the intermediate layer are disposed at the first side 1202; and removing the first substrate. In some embodiments, connecting the first connecting layer with the second connecting layer includes bonding the first connecting layer with the second connecting layer or adhering the first connecting layer to the second connecting layer.

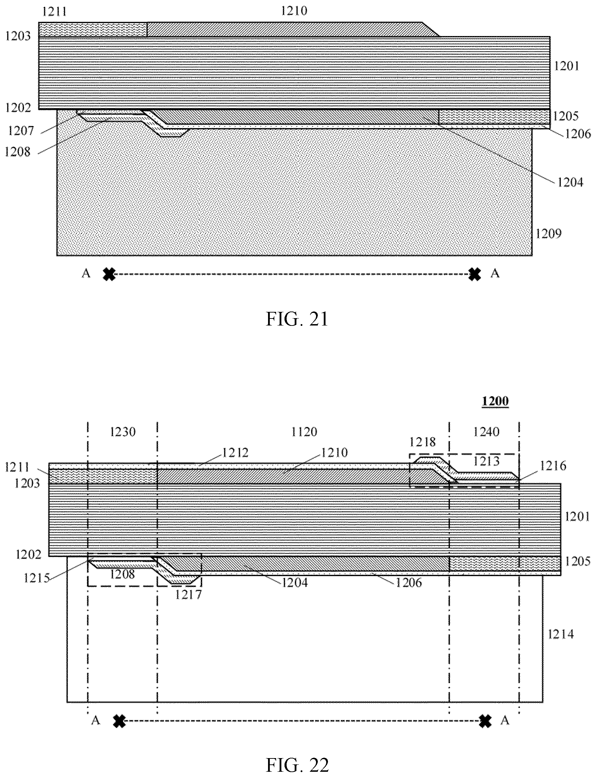

As shown in FIG. 21, the method for forming the bulk acoustic wave resonance device 1200 further includes: forming a second electrode layer 1210 at the second side 1203 and contacting the piezoelectric layer 1201, wherein the second electrode layer 1210 includes a third edge and a fourth edge opposite to the third edge in the horizontal direction; forming a second electrode extension layer 1211 at the second side 1203 and contacting the piezoelectric layer 1201. The second electrode extension layer 1211 is coupled with the third edge of the second electrode layer 1210. The third edge corresponds to the first edge in the vertical direction, and the fourth edge corresponds to the second edge in the vertical direction.

In some embodiments, forming the second electrode layer 1210 includes forming a second ramp-down edge at the fourth edge.

As shown in FIG. 22, the method for forming the bulk acoustic wave resonance device 1200 further includes: forming a second passivation layer 1212 at the second side 1203, wherein the second passivation layer 1212 covers the second electrode layer 1210, and also covers the second electrode extension layer 1211 outside the third edge; forming a gap sacrificial layer (not shown, for example, the first sacrificial layer 1207) disposed at the second side 1203 and outside the fourth edge, wherein the gap sacrificial layer contacts the piezoelectric layer 1201 and the second passivation layer 1212; forming a second overlap layer 1213 at the second side 1203 and contacting the second passivation layer 1212 and the gap sacrificial layer. The second overlap layer 1213 includes a second raised portion (not marked) and a second extension portion (not marked), and the second raised portion protrudes relative to the second extension portion. The second raised portion is disposed at an inner side to the fourth edge and overlaps with the second electrode layer 1210 at the fourth edge. The second raised portion and the second electrode layer 1210 are disposed at two opposite sides of the second passivation layer 1212. The second extension portion is outside the fourth edge, and does not overlap with the second electrode layer 1210. The second extension portion and the piezoelectric layer 1201 are disposed at two opposite sides of the gap sacrificial layer along the vertical direction.

In some embodiments, the method for forming the bulk acoustic wave resonance device 1200 further includes removing the second sacrificial layer 1209 to form a cavity 1214. The first electrode layer 1204, one end of the first electrode extension layer 1205 coupled with the second edge and the first overlap layer 1208 are disposed in the cavity 1214.

In some embodiments, the method for forming the bulk acoustic wave resonance device 1200 further includes removing the first sacrificial layer 1207 and the gap sacrificial layer to form a first gap 1215 and a second gap 1216, respectively.

In some embodiments, the first overlap layer 1208, the first dielectric portion (not marked) that is a part of the first passivation layer 1206 overlapping with the first overlap layer 1208 and the first gap 1215 form a first passive structure 1217. The first passive structure 1217 is disposed at the first side 1202 and contacts the first edge of the first electrode layer 1204. The second overlap layer 1213, a second dielectric portion (not marked) that is a part of the second passivation layer 1212 overlapping with the second overlap layer 1213 and the second gap 1216 form a second passive structure 1218. The second passive structure 1218 is disposed at the second side 1203 and contacts the fourth edge of the second electrode layer 1210. It should be noted that the dielectric portions can electrically isolate the overlap layers from the electrode layers, so that the electrode layers and the overlap layers are not electrically coupled, thus the overlap layers are passive, and thus a combination structure of the dielectric portion and the overlap layer is also passive.

In some embodiments, a first thickness of the first passive structure 1217 is less than a thickness of the first electrode layer 1204, a second thickness of the second passive structure 1218 is less than a thickness of the second electrode layer 1210, and the first thickness is equal to or approximately equal to the second thickness.

In some embodiments, an overlap region of the first electrode layer 1204, the second electrode layer 1210 and the piezoelectric layer 1201 forms a resonance region 1220, an overlap region of the first extension portion, the second electrode extension layer 1211, and the piezoelectric layer 1201 form an evanescent region 1230, and an overlap region of the second extension portion, the first electrode extension layer 1205 and the piezoelectric layer 1201 form an evanescent region 1240. A first cutoff frequency of the evanescent region 1230 matches with (for example, equal to or less than) a cutoff frequency of the resonance region 1220, a second cutoff frequency of the evanescent region 1240 matches with (for example, equal to or less than) the cutoff frequency of the resonance region 1220, and the first cutoff frequency is equal to or approximately equal to the second cutoff frequency.

In some embodiments, a first width of the first raised portion matches with a wavelength of major-mode transverse acoustic waves generated in the resonance region 1220. For example, the first width is an integer multiple of half the wavelength. A second width of the second raised portion matches with the wavelength of the major-mode transverse acoustic waves generated in the resonance region 1220. For example, the second width is equal to an integer multiple of half the wavelength, and the first width is equal to or approximately equal to the second width. It should be noted that the first raised portion and the second raised portion are used to make acoustic impedance matching of the resonance region and the evanescent region, so that more acoustic waves generated in the resonance region can propagate into the evanescent region.

In some embodiments, a third thickness of the first extension portion is less than the thickness of the first electrode layer 1204, a fourth thickness of the second extension portion is less than the thickness of the second electrode layer 1210, and the third thickness is equal to or approximately equal to the fourth thickness.

It should be noted that the cutoff frequency of the evanescent region matches with the cutoff frequency of the resonance region, which can result in the acoustic waves entering the evanescent region are in the evanescent mode, that is, the wave number in the evanescent region only includes an imaginary part, resulting in exponential decay of the acoustic waves. It should be noted that the passive structures can decay the transverse acoustic waves generated in the resonance region so as to suppress lateral spurious mode, to improve Zₚ and corresponding Q value. In addition, the passive structures are not electrically coupled with the electrode layers, thus the impact of the passive structures on Kt² is relatively small.

In some embodiments, forming the overlap layer includes forming a first overlap sub-layer contacting the passivation layer, and forming a second overlap sub-layer contacting the first overlap sub-layer. The second overlap sub-layer and the passivation layer are disposed at two opposite sides of the first overlap sub-layer. The material of the first overlap sub-layer may be different from that of the second overlap sub-layer, for example, the material of the first overlap sub-layer is molybdenum, and the material of the second overlap sub-layer is platinum or tungsten.

It should be noted that the raised portions of the passive structures are in the resonance region and overlap with the electrode layers, which can make acoustic impedance matching of the resonance region and the evanescent region outside the resonance region, so that more acoustic waves generated in the resonance region can propagate into the evanescent region. In addition, the cutoff frequency of the evanescent region matches with (for example, equal to or less than) the cutoff frequency of the resonance region, which can result in decaying the acoustic waves entering the evanescent region so as to suppress lateral spurious mode to improve Zₚ and corresponding Q value. The cutoff frequency is a frequency corresponding to a wave number of 0 on a dispersion curve. In addition, the passive structures are not electrically coupled with the electrode layers, thus the impact of the passive structures on Kt² is relatively small.

It should be understood that examples and embodiments herein are only exemplary, and those skilled in the art can make various modifications and corrections without departing from the spirit and scope of the present disclosure.

## Claims

1. A bulk acoustic wave resonance device, comprising:
a cavity;
a first electrode layer, wherein at least one end of the first electrode layer is disposed above or in the cavity;
a piezoelectric layer, wherein the piezoelectric layer comprises a first side and a second side opposite to the first side in a vertical direction, wherein the cavity is disposed at the first side, the first electrode layer is disposed at the first side, and the first electrode layer contacts the piezoelectric layer;
a second electrode layer, disposed at the second side and contacting the piezoelectric layer, wherein an overlap region of the first electrode layer, the second electrode layer and the piezoelectric layer forms a resonance region;
a first passive structure, disposed at the first side and having a first overlap portion overlapping with at least one edge of the first electrode layer; and
a second passive structure, disposed at the second side and having a second overlap portion overlapping with at least one edge of the second electrode layer;
wherein the first passive structure comprises:
a first raised portion, disposed in the resonance region and having the first overlap portion overlapping with the at least one edge of the first electrode layer, wherein the first raised portion is configured to make acoustic impedance matching of the resonance region and at least one evanescent region disposed outside the resonance region, so that more acoustic waves generated in the resonance region enter the at least one evanescent region;
a first dielectric portion, disposed between the first raised portion and the first electrode layer for electrically isolating the first passive structure from the first electrode layer; and
a first extension portion, disposed outside the resonance region and in the at least one evanescent region for decaying the acoustic waves entering the at least one evanescent region, wherein the first raised portion protrudes relative to the first extension portion;
wherein the second passive structure comprises:
a second raised portion, disposed in the resonance region and having the second overlap portion overlapping with the at least one edge of the second electrode layer, wherein the second raised portion is configured to make acoustic impedance matching of the resonance region and the at least one evanescent region, so that more acoustic waves generated in the resonance region enter the at least one evanescent region;
a second dielectric portion, disposed between the second raised portion and the second electrode layer for electrically isolating the second passive structure from the second electrode layer; and
a second extension portion, disposed outside the resonance region and in the at least one evanescent region for decaying the acoustic waves entering the at least one evanescent region, wherein the second raised portion protrudes relative to the second extension portion.

2. The bulk acoustic wave resonance device according to claim 1, wherein the first passive structure and the second passive structure surround the resonance region.

3. The bulk acoustic wave resonance device according to claim 1, wherein a thickness of the first passive structure is equal to or less than a thickness of the first electrode layer, and a thickness of the second passive structure is equal to or less than a thickness of the second electrode layer.

4. The bulk acoustic wave resonance device according to claim 1, wherein the at least one evanescent region comprises a first evanescent region having a first cutoff frequency equal to or less than a cutoff frequency of the resonance region, and the first evanescent region corresponds to an overlap region of the first extension portion, the piezoelectric layer and the second extension portion.

5. The bulk acoustic wave resonance device according to claim 1, further comprising:
a first electrode extension layer, disposed at the first side and coupled with the first electrode layer; and
a second electrode extension layer, disposed at the second side and coupled with the second electrode layer.

6. The bulk acoustic wave resonance device according to claim 5, wherein the at least one evanescent region comprises a second evanescent region having a second cutoff frequency equal to or less than a cutoff frequency of the resonance region, and the second evanescent region corresponds to an overlap region of the second electrode extension layer, the piezoelectric layer and the first extension portion.

7. The bulk acoustic wave resonance device according to claim 5, wherein the at least one evanescent region comprises a third evanescent region having a third cutoff frequency equal to or less than a cutoff frequency of the resonance region, and the third evanescent region corresponds to an overlap region of the second extension portion, the piezoelectric layer and the first electrode extension layer.

8. The bulk acoustic wave resonance device according to claim 1, wherein the at least one edge of the first electrode layer, corresponding to the first passive structure, has a ramp-down shape, and the at least one edge of the second electrode layer, corresponding to the second passive structure, has a ramp-down shape.

9. The bulk acoustic wave resonance device according to claim 1, wherein a width of the first raised portion is an integer multiple of a half wavelength of the acoustic waves generated in the resonance region, and a width of the second raised portion is an integer multiple of the half wavelength of the acoustic waves generated in the resonance region.

10. The bulk acoustic wave resonance device according to claim 1, wherein the first raised portion is made of a material including a metal, the first extension portion is made of a material including a metal, the second raised portion is made of a material including a metal, and the second extension portion is made of a material including a metal.

11. The bulk acoustic wave resonance device according to claim 1, wherein a thickness of the first extension portion is less than a thickness of the first electrode layer, and a thickness of the second extension portion is less than a thickness of the second electrode layer.

12. The bulk acoustic wave resonance device according to claim 1, wherein the first extension portion comprises a first sub-portion and a second sub-portion, the second sub-portion and the piezoelectric layer are disposed at two opposite sides of the first sub-portion, and a material of the first sub-portion is different from a material of the second sub-portion.

13. The bulk acoustic wave resonance device according to claim 1, wherein the second extension portion comprises a third sub-portion and a fourth sub-portion, the fourth sub-portion and the piezoelectric layer are disposed at two opposite sides of the third sub-portion, and a material of the third sub-portion is different from a material of the fourth sub-portion.

14. The bulk acoustic wave resonance device according to claim 1, wherein the first dielectric portion is made of a material selected from a group consisting of silicon dioxide, silicon oxynitride, silicon oxycarbide, silicon nitride, titanium oxide, aluminium oxide, hafnium silicate, zirconium silicate, hafnium dioxide and zirconium dioxide, and the second dielectric portion is made of a material selected from a group consisting of silicon dioxide, silicon oxynitride, silicon oxycarbide, silicon nitride, titanium oxide, aluminium oxide, hafnium silicate, zirconium silicate, hafnium dioxide and zirconium dioxide.

15. The bulk acoustic wave resonance device according to claim 1, wherein the first dielectric portion comprises one selected from a group consisting of vacuum, air and helium, and the second dielectric portion comprises one selected from a group consisting of vacuum, air and helium.

16. The bulk acoustic wave resonance device according to claim 15, wherein the first extension portion contacts the piezoelectric layer, and the second extension portion contacts the piezoelectric layer.

17. The bulk acoustic wave resonance device according to claim 1, wherein the first dielectric portion is further disposed between the piezoelectric layer and the first extension portion, and the second dielectric portion is further disposed between the piezoelectric layer and the second extension portion.

18. The bulk acoustic wave resonance device according to claim 1, wherein a first gap is disposed between the first extension portion and the piezoelectric layer, and a second gap is disposed between the piezoelectric layer and the second extension portion.

19. A filtering device, comprising at least one bulk acoustic wave resonance device according to any one of claims 1 to 18.

20. A radio frequency front-end device, comprising a power amplification device and at least one filtering device according to claim 19, wherein the power amplification device is coupled with the filtering device.

21. A radio frequency front-end device, comprising a low noise amplification device and at least one filtering device according to claim 19, wherein the low noise amplification device is coupled with the filtering device.

22. A radio frequency front-end device, comprising a multiplexing device, wherein the multiplexing device comprises at least one filtering device according to claim 19.

23. A method for forming a bulk acoustic wave resonance device, comprising:
forming a piezoelectric layer, wherein the piezoelectric layer comprises a first side and a second side opposite to the first side in a vertical direction;
forming a first electrode layer at the first side, wherein the first electrode layer contacts the piezoelectric layer;
forming a second electrode layer at the second side, wherein the second electrode layer contacts the piezoelectric layer, and an overlap region of the first electrode layer, the second electrode layer and the piezoelectric layer forms a resonance region;
forming a first passive structure at the first side, wherein the first passive structure has a first overlap portion overlapping with at least one edge of the first electrode layer; wherein the first passive structure comprises a first raised portion, a first dielectric portion and a first extension portion, and the first raised portion protrudes relative to the first extension portion; wherein the first raised portion is disposed in the resonance region and has the first overlap portion overlapping with the at least one edge of the first electrode layer, and the first raised portion is configured to make acoustic impedance matching of the resonance region and at least one evanescent region disposed outside the resonance region, so that more acoustic waves generated in the resonance region enter the at least one evanescent region; wherein the first dielectric portion is disposed between the first raised portion and the first electrode layer for electrically isolating the first passive structure from the first electrode layer; wherein the first extension portion is disposed outside the resonance region and in the at least one evanescent region for decaying the acoustic waves entering the at least one evanescent region; and
forming a second passive structure at the second side, wherein the second passive structure has a second overlap portion overlapping with at least one edge of the second electrode layer; wherein the second passive structure comprises a second raised portion, a second dielectric portion and a second extension portion, and the second raised portion protrudes relative to the second extension portion; wherein the second raised portion is disposed in the resonance region and has the second overlap portion overlapping with the at least one edge of the second electrode layer, and the second raised portion is configured to make acoustic impedance matching of the resonance region and the at least one evanescent region in acoustic impedance, so that more acoustic waves generated in the resonance region enter the at least one evanescent region; wherein the second dielectric portion is disposed between the second raised portion and the second electrode layer for electrically isolating the second passive structure from the second electrode layer; wherein the second extension portion is disposed outside the resonance region and in the at least one evanescent region for decaying the acoustic waves entering the at least one evanescent region.

24. The method according to claim 23, wherein the first passive structure and the second passive structure surround the resonance region.

25. The method according to claim 23, wherein a thickness of the first passive structure is equal to or less than a thickness of the first electrode layer, and a thickness of the second passive structure is equal to or less than a thickness of the second electrode layer.

26. The method according to claim 23, wherein forming the first electrode layer comprises forming at least one edge, corresponding to the first passive structure, having a ramp-down shape, and forming the second electrode layer comprises forming at least one edge, corresponding to the second passive structure, having a ramp-down shape.

27. The method according to claim 23, wherein forming the first passive structure comprises:
forming a first passivation layer at the first side covering the first electrode layer; and
forming a first overlap layer contacting the first passivation layer and having the first overlap portion overlapping with the at least one edge of the first electrode layer;
wherein the first passivation layer comprises the first dielectric portion, and the first overlap layer comprises the first raised portion and the first extension portion.

28. The method according to claim 23, wherein forming the second passive structure comprises:
forming a second passivation layer at the second side covering the second electrode layer; and
forming a second overlap layer contacting the second passivation layer and having the second overlap portion overlapping with the at least one edge of the second electrode layer;
wherein the second passivation layer comprises the second dielectric portion, and the second overlap layer comprises the second raised portion and the second extension portion.

29. The method according to claim 23, wherein a thickness of the first extension portion is less than a thickness of the first electrode layer, and a thickness of the second extension portion is less than a thickness of the second electrode layer.

30. The method according to claim 23, wherein the at least one evanescent region comprises a first evanescent region having a first cutoff frequency equal to or less than a cutoff frequency of the resonance region, and the first evanescent region corresponds to an overlap region of the first extension portion, the piezoelectric layer and the second extension portion.

31. The method according to claim 23, further comprising:
forming a first electrode extension layer at the first side, wherein the first electrode extension layer is coupled with the first electrode layer; and
forming a second electrode extension layer at the second side, wherein the second electrode extension layer is coupled with the second electrode layer.

32. The method according to claim 31, wherein the at least one evanescent region comprises a second evanescent region having a second cutoff frequency equal to or less than a cutoff frequency of the resonance region, and the second evanescent region corresponds to an overlap region of the second electrode extension layer, the piezoelectric layer and the first extension portion.

33. The method according to claim 31, wherein the at least one evanescent region comprises a third evanescent region having a third cutoff frequency equal to or less than a cutoff frequency of the resonance region, and the third evanescent region corresponds to an overlap region of the second extension portion, the piezoelectric layer and the first electrode extension layer.

34. The method according to claim 23, wherein a width of the first raised portion is an integer multiple of a half wavelength of the acoustic waves generated in the resonance region, and a width of the second raised portion is an integer multiple of the half wavelength of the acoustic waves generated in the resonance region.

35. The method according to claim 27, wherein forming the first overlap layer comprises forming a first overlap sub-layer and a second overlap sub-layer, the second overlap sub-layer and the piezoelectric layer are disposed at two opposite sides of the first overlap sub-layer, and a material of the first overlap sub-layer is different from a material of the second overlap sub-layer.

36. The method according to claim 28, wherein forming the second overlap layer comprises forming a third overlap sub-layer and a fourth overlap sub-layer, the fourth overlap sub-layer and the piezoelectric layer are disposed at two opposite sides of the third overlap sub-layer, and a material of the third overlap sub-layer is different from a material of the fourth overlap sub-layer.

37. The method according to claim 23, further comprising:
forming a first sacrificial layer between the first extension portion and the piezoelectric layer; and
forming a second sacrificial layer between the second extension portion and the piezoelectric layer.

38. The method according to claim 37, further comprising:
removing the first sacrificial layer to form a first gap between the first extension portion and the piezoelectric layer; and
removing the second sacrificial layer to form a second gap between the second extension portion and the piezoelectric layer.

39. The method according to claim 23, wherein the first dielectric portion is further disposed between the piezoelectric layer and the first extension portion, and the second dielectric portion is further disposed between the piezoelectric layer and the second extension portion.
